# EUROPEAN PATENT APPLICATION

(11) **EP 4 685 416 A1**
(43) Date of publication of application: **28.01.2026**
(21) Application number: 25188587.7
(22) Date of filing: 09.07.2025
(51) Int. Cl.: F25B 25/00, F25B 1/00, F25B 5/02, F25B 23/00, F25B 49/02, F28D 15/02, F25B 41/00

(54) **MIXED MODE MODULAR COOLING SYSTEM AND OPERATING METHOD THEREOF**

(30) Priority: 10.07.2024 US 202463669487 P
(71) Applicant: Vertiv Corporation, Westerville, OH 43082 (US)
(72) Inventor: Giancarlo, FURLAN, Westerville, 43082 (US); Marco, VIANELLO, Westerville, 43082 (US)
(74) Representative: Beal, James Michael

(57) **Abstract**

A mixed mode modular cooling system can include two or more mixed mode refrigerant loops and plumbing to permit a working fluid to circulate through at least a portion of the loops. Each mixed mode refrigerant loop can include an evaporator, a condenser, a pump to pump a refrigerant through the evaporator and the condenser, and a compressor configured to compress the refrigerant between the evaporator and the condenser. As cooling demand varies, each mixed mode refrigerant loop can be brought online and operated in either compressed refrigerant mode or pumped refrigerant mode.

## Description

### CROSS REFERENCE TO RELATED APPLICATIONS

This application claims the benefit of U.S. Provisional Patent Application No. 63/669,487 filed July 10, 2024, entitled "Modular Chiller With Pumped Refrigerant Economizer".

### TECHNICAL FIELD

The present disclosure relates generally to heat exchanger systems and more specifically relates to multi-stage cooling systems.

### BACKGROUND

There are numerous manufacturers offering chillers, such as for the data center market. Many chillers use compressors that allow for high efficiency in modulation. Alternatively, a few manufacturers adopt a system with a thermosiphon or a pumped refrigerant economizer (PRE), turning off the compressor at low temperatures. While free cooling can work in combination with the compressors, it often worsens the performance at high temperatures due to the additional coils. Current PRE systems retain efficiency with high ambient temperatures, but only work in the alternative to compressors, losing opportunities for additional efficiency at intermediate temperatures.

### SUMMARY

Applicant has created new and useful devices, systems and methods for mixed mode split cooling systems. In at least one embodiment, a method of operating a modular cooling system can include monitoring a cooling demand, starting a first mixed mode refrigerant loop in pumped refrigerant mode as the cooling demand rises to a first demand level, operating the first mixed mode refrigerant loop in pumped refrigerant mode and starting a second mixed mode refrigerant loop in pumped refrigerant mode as the cooling demand rises from the first demand level to a second demand level, operating the second mixed mode refrigerant loop in pumped refrigerant mode and switching the first mixed mode refrigerant loop from pumped refrigerant mode to compressed refrigerant mode as the cooling demand rises from the second demand level to a third demand level, operating the first mixed mode refrigerant loop in compressed refrigerant mode and switching the second mixed mode refrigerant loop from pumped refrigerant mode to compressed refrigerant mode as the cooling demand rises from the third demand level to a fourth demand level, or any combination thereof.

In at least one embodiment, starting the first mixed mode refrigerant loop in pumped refrigerant mode can include opening a first flow valve, starting a first pump, pumping a first two-phase refrigerant through a first condenser and a first evaporator, or any combination thereof. In at least one embodiment, starting the second mixed mode refrigerant loop in pumped refrigerant mode can include opening a second flow valve, starting a second pump, pumping a second two-phase refrigerant through a second condenser and a second evaporator, or any combination thereof.

In at least one embodiment, switching the first mixed mode refrigerant loop from pumped refrigerant mode to compressed refrigerant mode can include leaving the first flow valve open, stopping the first pump, starting a first compressor, compressing the first two-phase refrigerant between the first evaporator and the first condenser, or any combination thereof. In at least one embodiment, switching the second mixed mode refrigerant loop from pumped refrigerant mode to compressed refrigerant mode can include leaving the second flow valve open, stopping the second pump, starting a second compressor, compressing the second two-phase refrigerant between the second evaporator and the second condenser, or any combination thereof.

In at least one embodiment, the second demand level can indicate greater cooling demand than the first demand level. In at least one embodiment, the third demand level can indicate greater cooling demand than the second demand level. In at least one embodiment, the fourth demand level can indicate greater cooling demand than the third demand level.

In at least one embodiment, a method of operating a modular cooling system can include, such as when the cooling demand varies between the first demand level and the second demand level, varying a first pump speed of a first pump of the first mixed mode refrigerant loop. In at least one embodiment, a method of operating a modular cooling system can include, such as when the cooling demand varies between the second demand level and the third demand level, running the first pump at its maximum rated speed and/or varying a second pump speed of a second pump of the second mixed mode refrigerant loop.

In at least one embodiment, a method of operating a modular cooling system can include, such as when the cooling demand varies between the third demand level and the fourth demand level, running the second pump at its maximum rated speed and/or varying a first compressor speed of a first compressor of the first mixed mode refrigerant loop. In at least one embodiment, a method of operating a modular cooling system can include, such as when the cooling demand varies between the third demand level and the fourth demand level, running a first compressor of the first mixed mode refrigerant loop at its maximum compressor speed and/or varying the second pump speed of the second pump.

In at least one embodiment, a method of operating a modular cooling system can include, such as when the cooling demand varies above the fourth demand level, running the first compressor at its maximum compressor speed and/or varying a second compressor speed of a second compressor of the second mixed mode refrigerant loop. In at least one embodiment, a method of operating a modular cooling system can include, such as when the cooling demand varies above the fourth demand level, varying the first compressor speed and/or running a second compressor at its maximum compressor speed.

In at least one embodiment, the first mixed mode refrigerant loop and the second mixed mode refrigerant loop can have the same or different cooling capacities in pumped refrigerant mode. In at least one embodiment, the first mixed mode refrigerant loop and the second mixed mode refrigerant loop can have the same or different cooling capacities in compressed refrigerant mode.

In at least one embodiment, a method of operating a modular cooling system can include monitoring a cooling demand. In at least one embodiment, a method of operating a modular cooling system can include, such as when the cooling demand varies between a first demand level and a second demand level, operating a first mixed mode refrigerant loop in pumped refrigerant mode, while isolating a second mixed mode refrigerant loop. In at least one embodiment, a method of operating a modular cooling system can include, such as when the cooling demand varies between the second demand level and a third demand level, operating both the first mixed mode refrigerant loop and the second mixed mode refrigerant loop in pumped refrigerant mode. In at least one embodiment, a method of operating a modular cooling system can include, such as when the cooling demand varies between the third demand level and a fourth demand level, operating the first mixed mode refrigerant loop in compressed refrigerant mode and the second mixed mode refrigerant loop in pumped refrigerant mode. In at least one embodiment, a method of operating a modular cooling system can include, such as when the cooling demand varies above the fourth demand level, operating both the first mixed mode refrigerant loop and the second mixed mode refrigerant loop in compressed refrigerant mode.

In at least one embodiment, operating the first mixed mode refrigerant loop in pumped refrigerant mode can include circulating a working fluid through a first evaporator of the first mixed mode refrigerant loop and a heat exchanger, pumping a first refrigerant through a first condenser of the first mixed mode refrigerant loop and the first evaporator, rejecting heat from the heat exchanger out of the first condenser, or any combination thereof. In at least one embodiment, isolating the second mixed mode refrigerant loop can include trapping a portion of the working fluid in a second evaporator of the second mixed mode refrigerant loop and/or isolating the second evaporator from the heat exchanger.

In at least one embodiment, operating both the first mixed mode refrigerant loop and the second mixed mode refrigerant loop in pumped refrigerant mode can include circulating a working fluid through a first evaporator of the first mixed mode refrigerant loop, a second evaporator of the second mixed mode refrigerant loop, and a heat exchanger. In at least one embodiment, operating both the first mixed mode refrigerant loop and the second mixed mode refrigerant loop in pumped refrigerant mode can include pumping a first refrigerant through a first condenser of the first mixed mode refrigerant loop and the first evaporator, thereby rejecting heat from the heat exchanger out of the first condenser. In at least one embodiment, operating both the first mixed mode refrigerant loop and the second mixed mode refrigerant loop in pumped refrigerant mode can include pumping a second refrigerant through a second condenser of the second mixed mode refrigerant loop and the second evaporator, thereby rejecting heat from the heat exchanger out of the second condenser.

In at least one embodiment, operating the first mixed mode refrigerant loop in compressed refrigerant mode and the second mixed mode refrigerant loop in pumped refrigerant mode can include circulating a working fluid through a first evaporator of the first mixed mode refrigerant loop, a second evaporator of the second mixed mode refrigerant loop, and a heat exchanger. In at least one embodiment, operating the first mixed mode refrigerant loop in compressed refrigerant mode and the second mixed mode refrigerant loop in pumped refrigerant mode can include compressing a first refrigerant between the first evaporator and a first condenser of the first mixed mode refrigerant loop, thereby rejecting heat from the heat exchanger out of the first condenser. In at least one embodiment, operating the first mixed mode refrigerant loop in compressed refrigerant mode and the second mixed mode refrigerant loop in pumped refrigerant mode can include pumping a second refrigerant through a second condenser of the second mixed mode refrigerant loop and the second evaporator, thereby rejecting heat from the heat exchanger out of the second condenser.

In at least one embodiment, operating both the first mixed mode refrigerant loop and the second mixed mode refrigerant loop in compressed refrigerant mode can include circulating a working fluid through a first evaporator of the first mixed mode refrigerant loop, a second evaporator of the second mixed mode refrigerant loop, and a heat exchanger. In at least one embodiment, operating both the first mixed mode refrigerant loop and the second mixed mode refrigerant loop in compressed refrigerant mode can include compressing a first refrigerant between the first evaporator and a first condenser of the first mixed mode refrigerant loop, thereby rejecting heat from the heat exchanger out of the first condenser. In at least one embodiment, operating both the first mixed mode refrigerant loop and the second mixed mode refrigerant loop in compressed refrigerant mode can include compressing a second refrigerant between the second evaporator and a second condenser of the second mixed mode refrigerant loop, thereby rejecting heat from the heat exchanger out of the second condenser.

In at least one embodiment, a mixed mode modular cooling system can include a first mixed mode refrigerant loop, a second mixed mode refrigerant loop, and plumbing to permit a working fluid to circulate through at least a part of the loops. In at least one embodiment, the first mixed mode refrigerant loop can include a first evaporator, a first condenser, a first pump to pump a first refrigerant through the first evaporator and the first condenser, a first compressor to compress the first refrigerant between the first evaporator and the first condenser, or any combination thereof. In at least one embodiment, the second mixed mode refrigerant loop can include a second evaporator, a second condenser, a second pump to pump a second refrigerant through the second evaporator and the second condenser, a second compressor to compress the second refrigerant between the second evaporator and the second condenser, or any combination thereof. In at least one embodiment, the plumbing can permit a working fluid to circulate through a heat exchanger, the first evaporator, the second evaporator, or any combination thereof.

In at least one embodiment, the plumbing can include a first valve to selectively permit the working fluid to circulate through the first evaporator and/or a second valve to selectively permit the working fluid to circulate through the second evaporator. In at least one embodiment, the plumbing can include a first input valve to selectively permit the working fluid to flow into the first evaporator and selectively prevent the working fluid from flowing into the first evaporator and/or a first output valve to selectively permit the working fluid to flow out of the first evaporator and selectively prevent the working fluid from flowing from the first evaporator, a second input valve to selectively permit the working fluid to flow into the second evaporator and selectively prevent the working fluid from flowing into the second evaporator and/or a second output valve to selectively permit the working fluid to flow out of the second evaporator and selectively prevent the working fluid from flowing from the second evaporator, or any combination thereof. In at least one embodiment, the plumbing can include an input manifold, such as between the first and second evaporator and/or input valves and the heat exchanger, and/or an output manifold, such as between the first and second evaporator and/or output valves and the heat exchanger.

In at least one embodiment, a method of operating a modular cooling system can include monitoring a cooling demand. In at least one embodiment, a method of operating a modular cooling system can include starting a first mixed mode refrigerant loop in pumped refrigerant mode, such as when the cooling demand rises to a first demand level. In at least one embodiment, a method of operating a modular cooling system can include switching the first mixed mode refrigerant loop from pumped refrigerant mode to compressed refrigerant mode, such as when the cooling demand rises from the first demand level to a second demand level. In at least one embodiment, a method of operating a modular cooling system can include operating the first mixed mode refrigerant loop in compressed refrigerant mode and/or starting a second mixed mode refrigerant loop in pumped refrigerant mode, such as when the cooling demand rises from the second demand level to a third demand level. In at least one embodiment, a method of operating a modular cooling system can include operating the first mixed mode refrigerant loop in compressed refrigerant mode and/or switching the second mixed mode refrigerant loop from pumped refrigerant mode to compressed refrigerant mode, such as when the cooling demand rises from the third demand level to a fourth demand level.

In at least one embodiment, a method of operating a modular cooling system can include, such as when the cooling demand varies between the first demand level and the second demand level, varying a first pump speed of a first pump of the first mixed mode refrigerant loop. In at least one embodiment, a method of operating a modular cooling system can include, such as when the cooling demand varies between the second demand level and the third demand level, varying a first compressor speed of a first compressor of the first mixed mode refrigerant loop.

In at least one embodiment, a method of operating a modular cooling system can include, such as when the cooling demand varies between the third demand level and the fourth demand level, running the first compressor at its maximum rated speed and/or varying a second pump speed of a second pump of the second mixed mode refrigerant loop. In at least one embodiment, a method of operating a modular cooling system can include, such as when the cooling demand varies between the third demand level and the fourth demand level, varying the first compressor speed and/or running the second pump at its maximum rated speed.

In at least one embodiment, a method of operating a modular cooling system can include, such as when the cooling demand varies above the fourth demand level, running the first compressor at its maximum rated speed and/or varying a second compressor speed of a second compressor of the second mixed mode refrigerant loop. In at least one embodiment, a method of operating a modular cooling system can include, such as when the cooling demand varies above the fourth demand level, varying the first compressor speed and/or running the second compressor at its maximum rated speed.

In at least one embodiment, a method of operating a modular cooling system can include monitoring a cooling demand. In at least one embodiment, a method of operating a modular cooling system can include, such as when the cooling demand varies between a first demand level and a second demand level, operating a first mixed mode refrigerant loop in pumped refrigerant mode, while isolating a second mixed mode refrigerant loop. In at least one embodiment, a method of operating a modular cooling system can include, such as when the cooling demand varies between the second demand level and a third demand level, operating the first mixed mode refrigerant loop in compressed refrigerant mode, while isolating the second mixed mode refrigerant loop. In at least one embodiment, a method of operating a modular cooling system can include, such as when the cooling demand varies between the third demand level and a fourth demand level, operating the first mixed mode refrigerant loop in compressed refrigerant mode and the second mixed mode refrigerant loop in pumped refrigerant mode. In at least one embodiment, a method of operating a modular cooling system can include, such as when the cooling demand varies above the fourth demand level, operating both the first mixed mode refrigerant loop and the second mixed mode refrigerant loop in compressed refrigerant mode.

In at least one embodiment, a method of operating a modular cooling system can include operating a first mixed mode refrigerant loop in compressed refrigerant mode, operating a second mixed mode refrigerant loop in pumped refrigerant mode, and monitoring a cooling demand. In at least one embodiment, a method of operating a modular cooling system can include operating the first mixed mode refrigerant loop in compressed refrigerant mode and switching the second mixed mode refrigerant loop from pumped refrigerant mode to compressed refrigerant mode, as the cooling demand rises. In at least one embodiment, a method of operating a modular cooling system can include operating the second mixed mode refrigerant loop in pumped refrigerant mode and switching the first mixed mode refrigerant loop from compressed refrigerant mode to pumped refrigerant mode, as the cooling demand falls. Embodiments of the disclosure can include any number of mixed mode refrigerant loops and cooling modes required or desired according to a given physical implementation.

### BRIEF DESCRIPTION OF THE DRAWINGS

FIG. 1 is a simplified schematic of one of many embodiments of a mixed mode modular cooling system according to the disclosure.
FIG. 2 is a diagram depicting different operating modes of one of many embodiments of a mixed mode modular cooling system according to the disclosure.
FIG. 3 is a simplified schematic of one of many embodiments of a mixed mode modular cooling system according to the disclosure, configured for no, or little, demand.
FIG. 4 is a simplified schematic of one of many embodiments of a mixed mode modular cooling system according to the disclosure, configured for a first demand level.
FIG. 5 is a simplified schematic of one of many embodiments of a mixed mode modular cooling system according to the disclosure, configured for a second demand level.
FIG. 6 is a simplified schematic of one of many embodiments of a mixed mode modular cooling system according to the disclosure, configured for a third demand level.
FIG. 7 is a simplified schematic of one of many embodiments of a mixed mode modular cooling system according to the disclosure, configured for a fourth demand level.
FIG. 8 is a simplified schematic of one of many embodiments of a mixed mode modular cooling system according to the disclosure, configured for a fifth demand level.
FIG. 9 is a simplified schematic of one of many embodiments of a mixed mode modular cooling system according to the disclosure, configured for a sixth demand level.
FIG. 10 is an operating graph of one of many embodiments of a mixed mode modular cooling system according to the disclosure.
FIG. 11 is a simplified schematic of another one of many embodiments of a mixed mode modular cooling system according to the disclosure, configured for a first demand level.
FIG. 12 is a simplified schematic of another one of many embodiments of a mixed mode modular cooling system according to the disclosure, configured for a second demand level.
FIG. 13 is a simplified schematic of another one of many embodiments of a mixed mode modular cooling system according to the disclosure, configured for a third demand level.
FIG. 14 is a simplified schematic of another one of many embodiments of a mixed mode modular cooling system according to the disclosure, configured for a fourth demand level.
FIG. 15 is a simplified schematic of another one of many embodiments of a mixed mode modular cooling system according to the disclosure, configured for a fifth demand level.
FIG. 16 is a simplified schematic of another one of many embodiments of a mixed mode modular cooling system according to the disclosure, configured for a sixth demand level.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for mixed mode split cooling systems. In at least one embodiment, a mixed mode modular cooling system according to the disclosure can include a plurality of mixed mode refrigerant loops and plumbing to permit a working fluid to circulate through at least a part of the loops. Each of the refrigerant loops can be independently operated in a pumped refrigerant mode or a compressed refrigerant mode, depending on cooling demand. For example, one refrigerant loop can be operated in a pumped refrigerant mode, while other refrigerant loops can be operated in a compressed refrigerant mode, and vice versa. In this manner, a mixed mode modular cooling system according to the disclosure can efficiently accommodate a wide range of cooling demands, which can include having any number of mixed modes required or desired in accordance with an implementation of the disclosure.

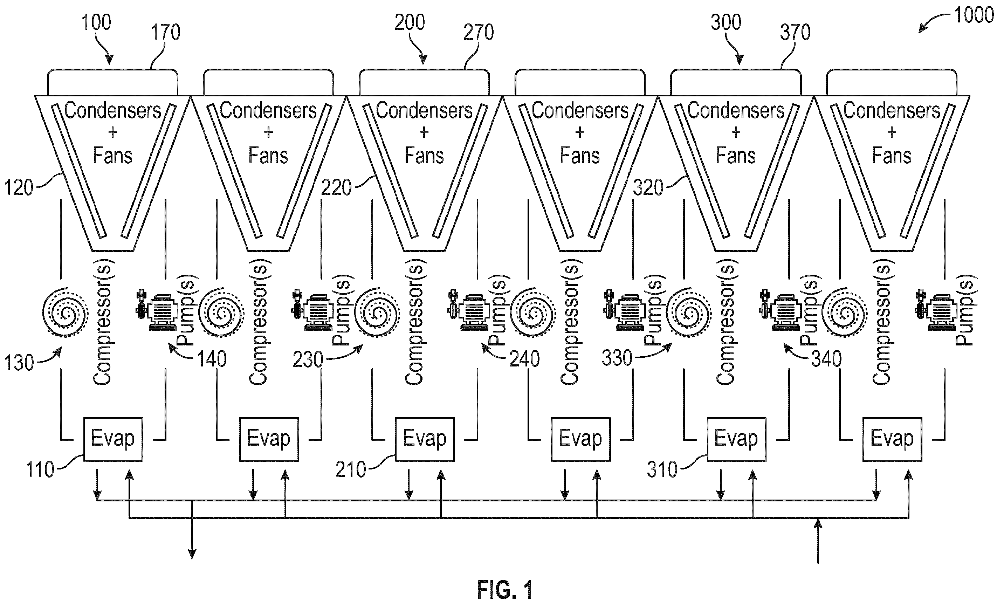

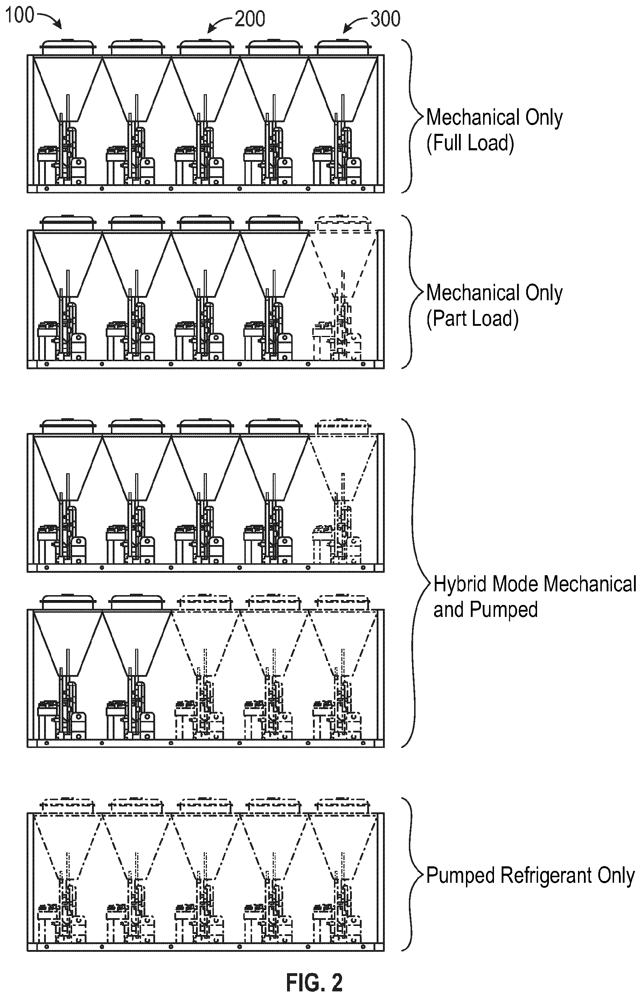

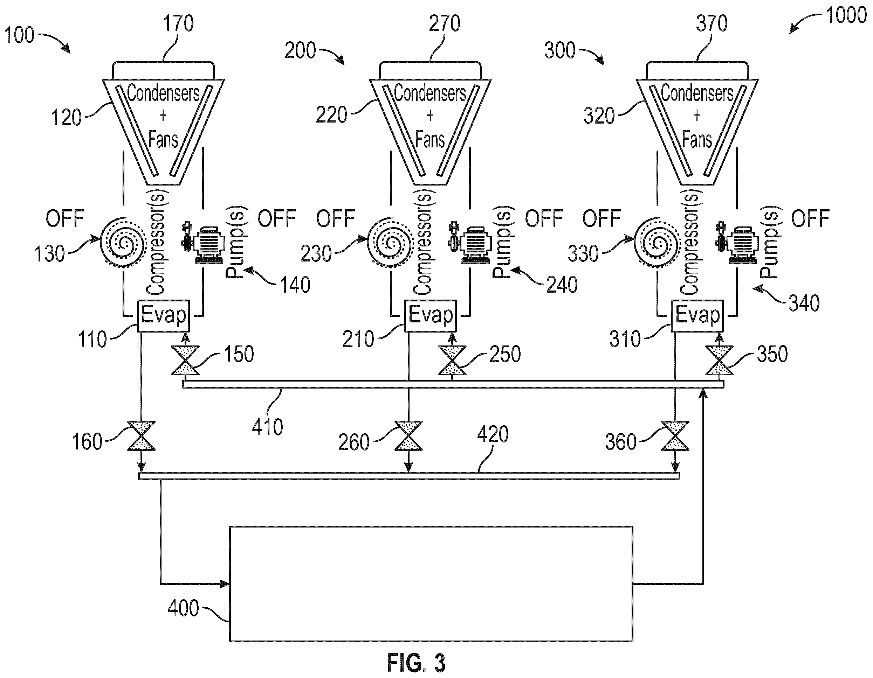

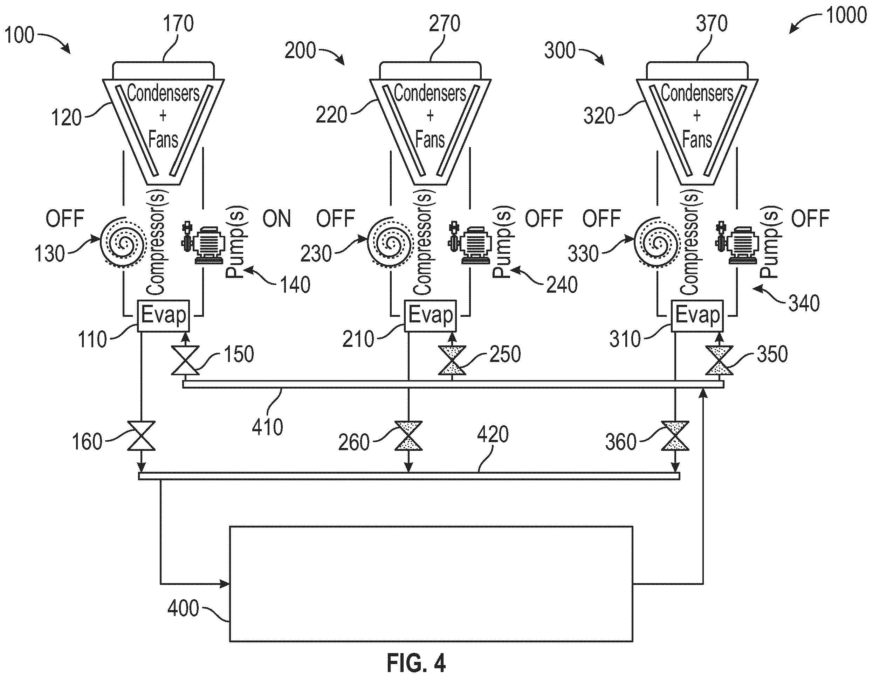

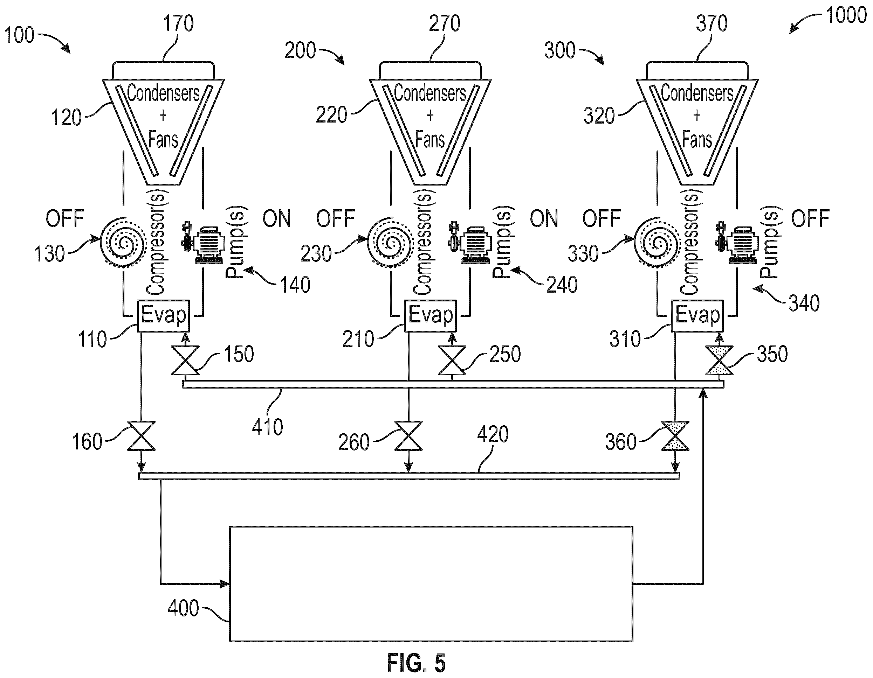

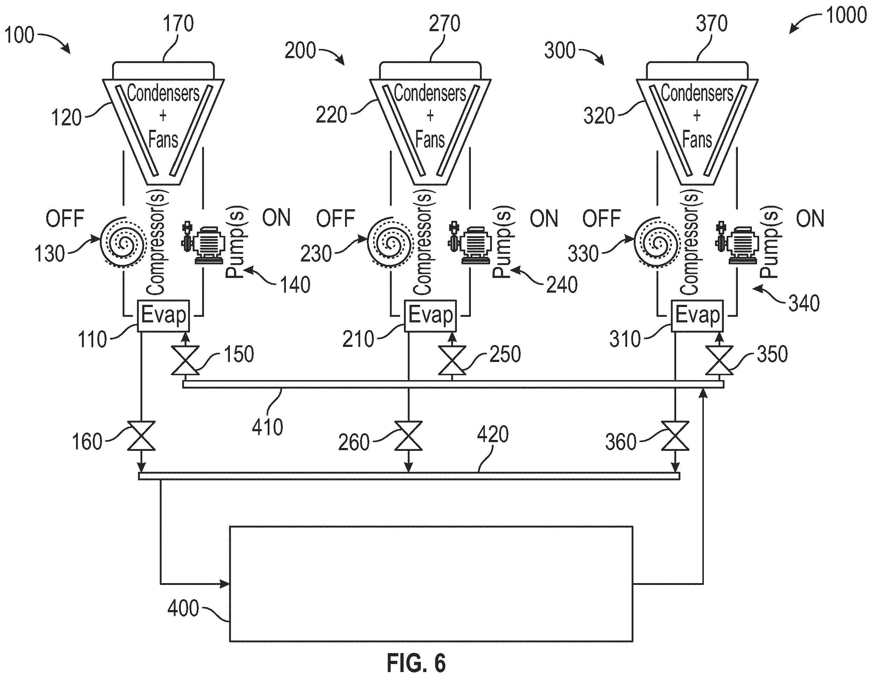

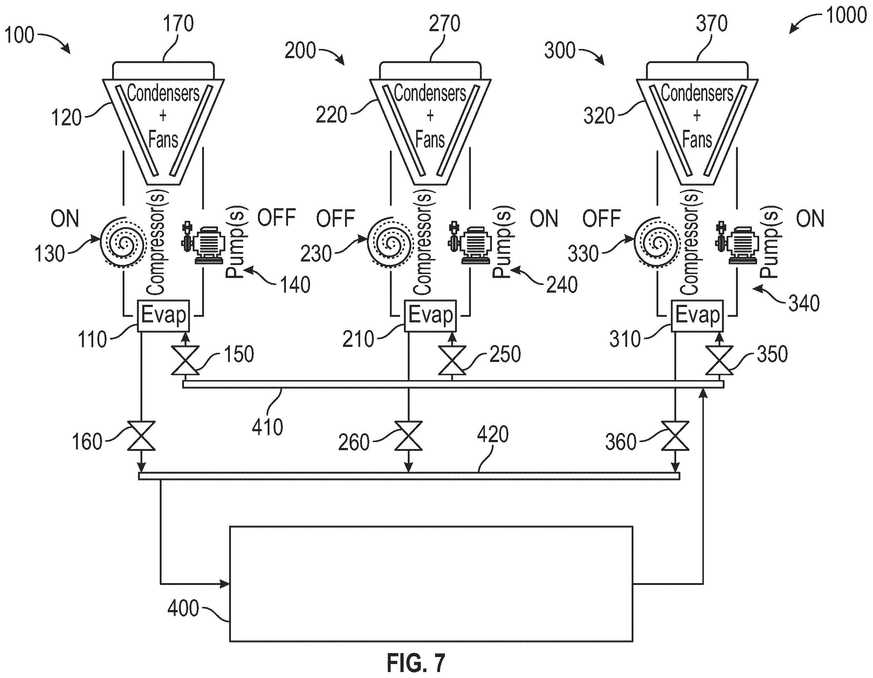

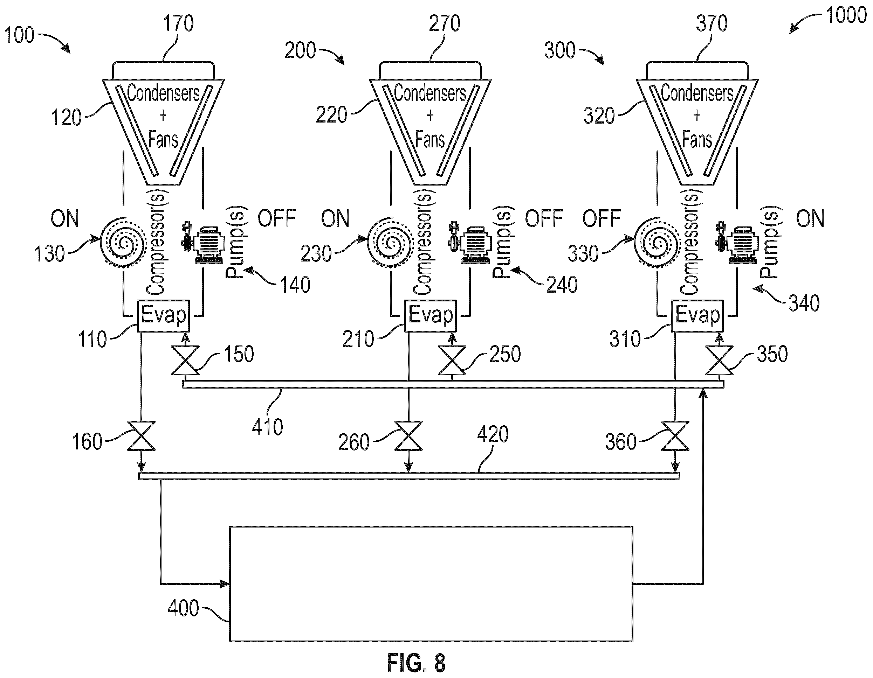

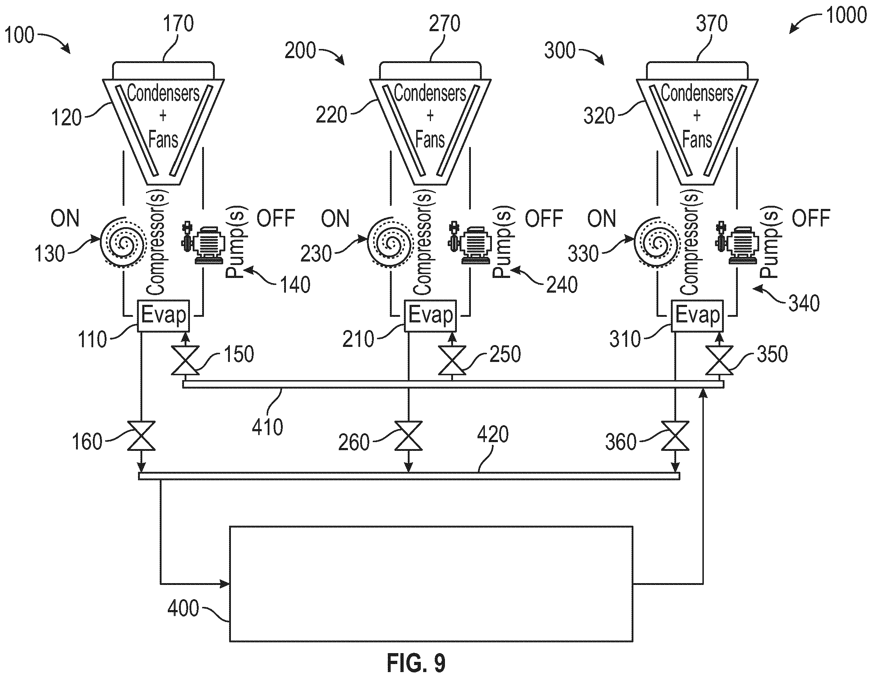

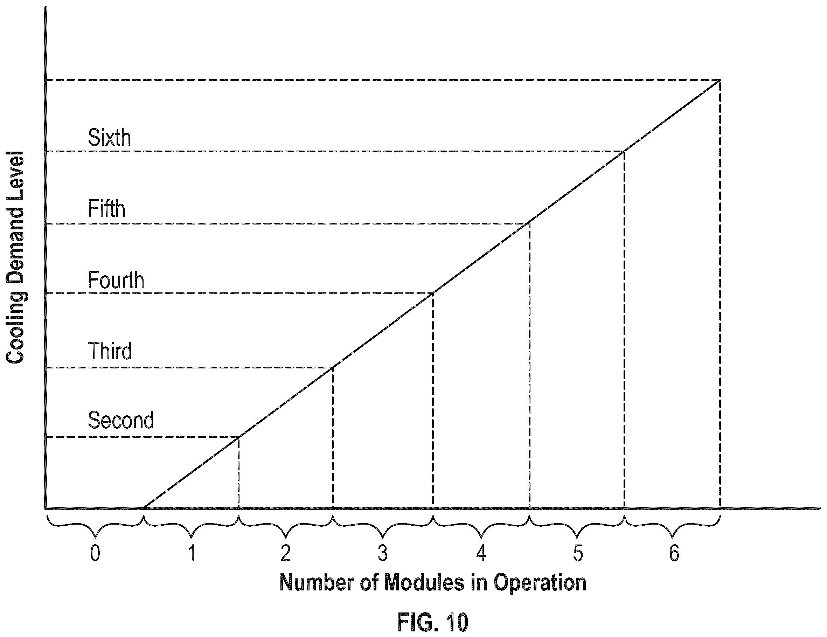

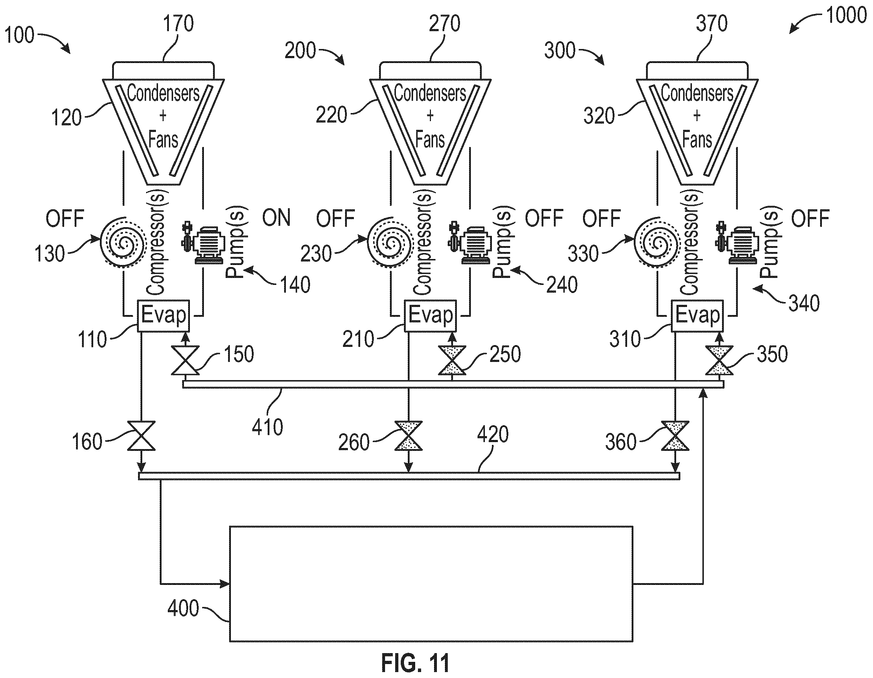

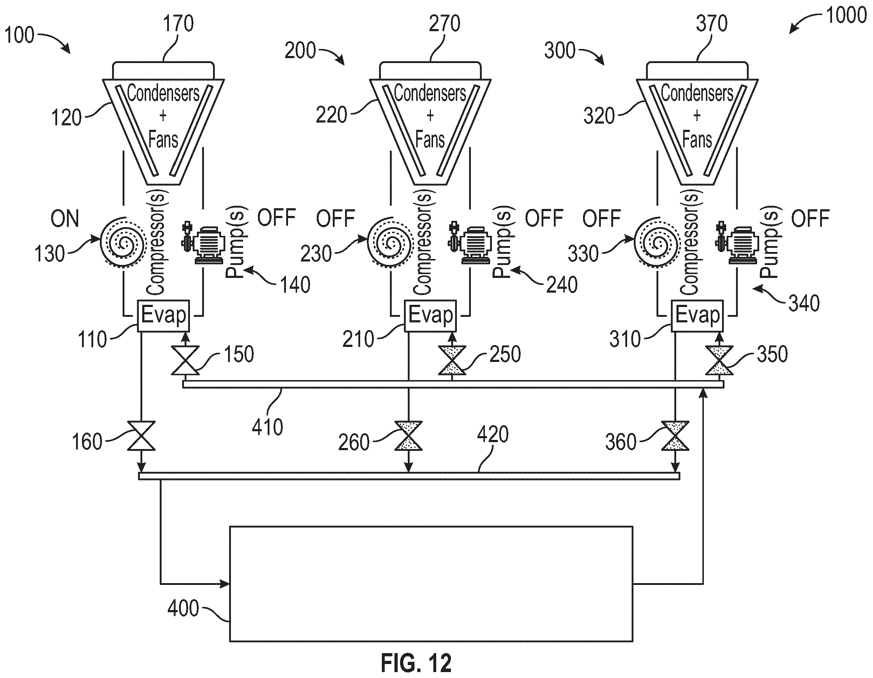

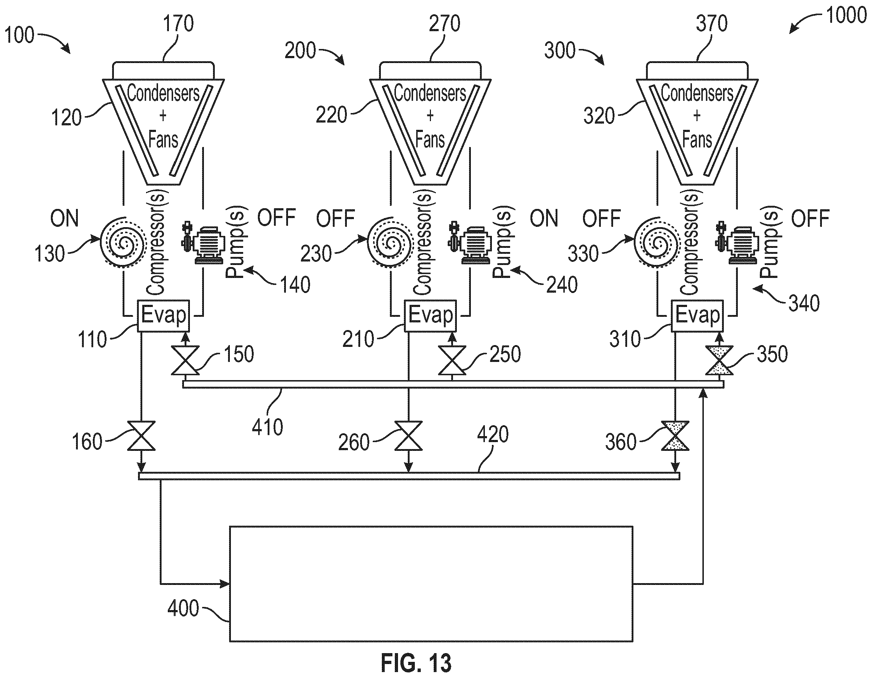

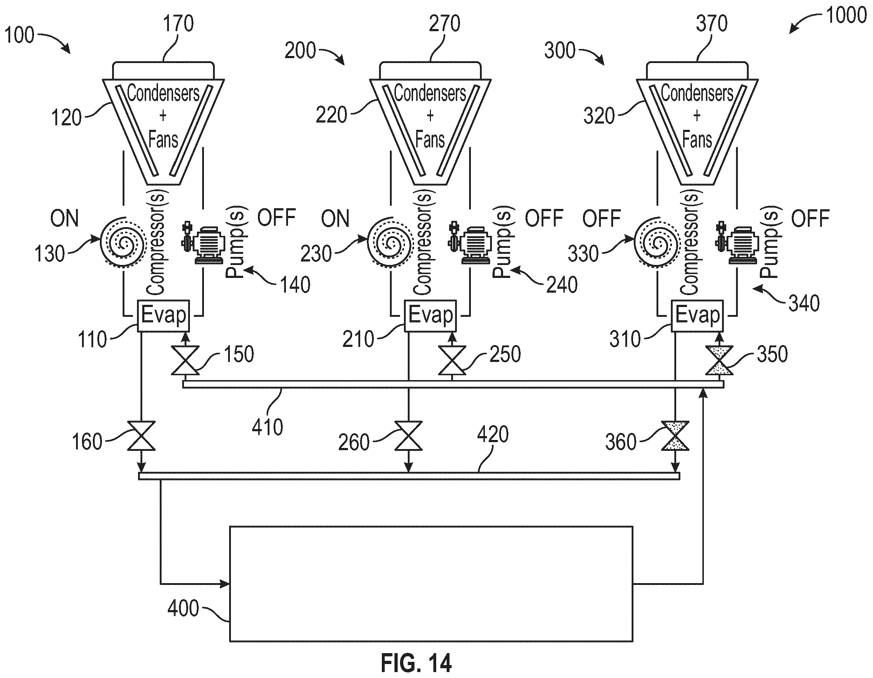

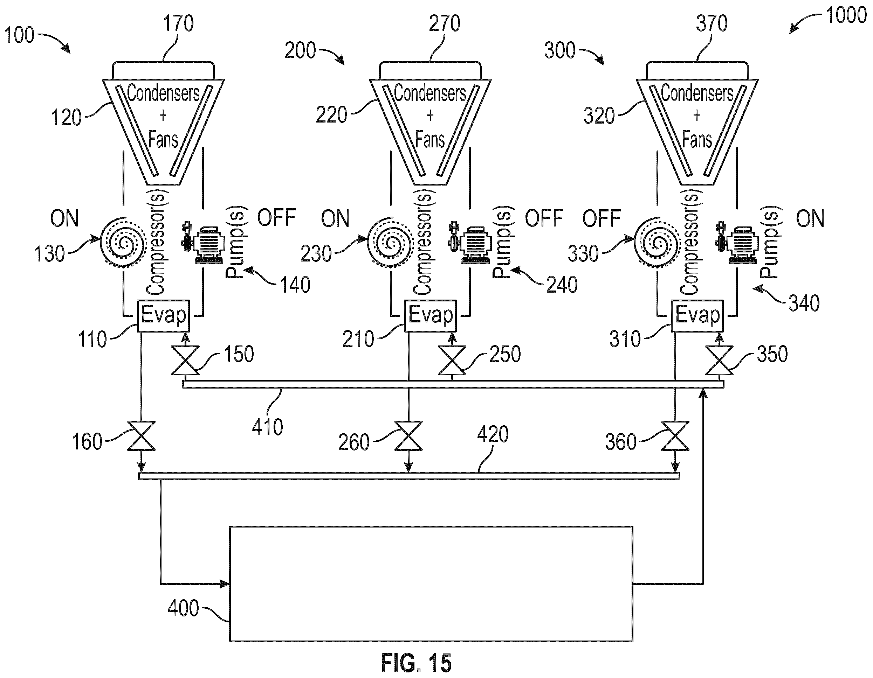

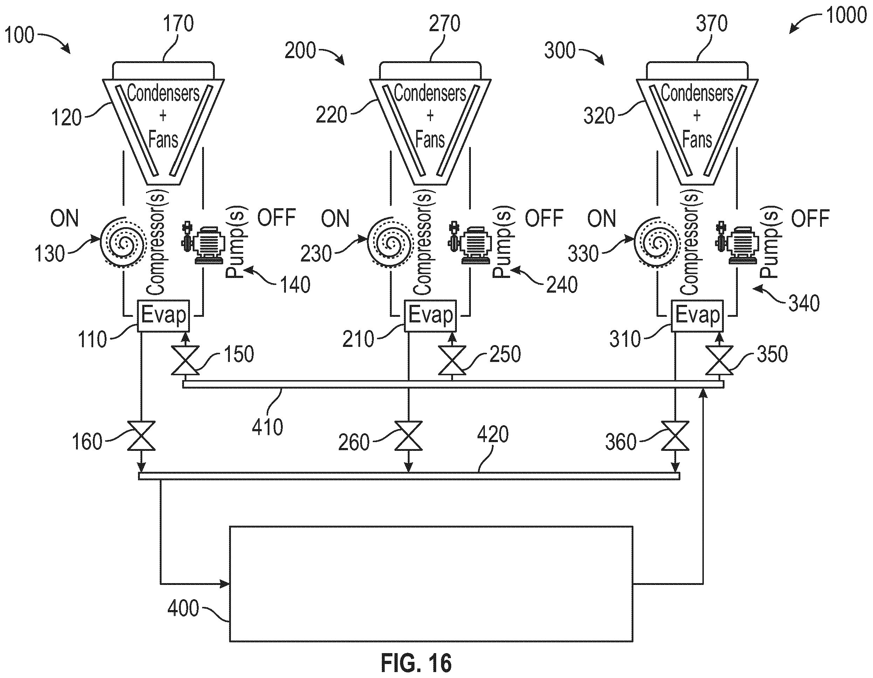

FIG. 1 is a simplified schematic of one of many embodiments of a mixed mode modular cooling system according to the disclosure. FIG. 2 is a diagram depicting different operating modes of one of many embodiments of a mixed mode modular cooling system according to the disclosure. FIG. 3 is a simplified schematic of one of many embodiments of a mixed mode modular cooling system according to the disclosure, configured for no, or little, demand. FIG. 4 is a simplified schematic of one of many embodiments of a mixed mode modular cooling system according to the disclosure, configured for a first demand level. FIG. 5 is a simplified schematic of one of many embodiments of a mixed mode modular cooling system according to the disclosure, configured for a second demand level. FIG. 6 is a simplified schematic of one of many embodiments of a mixed mode modular cooling system according to the disclosure, configured for a third demand level. FIG. 7 is a simplified schematic of one of many embodiments of a mixed mode modular cooling system according to the disclosure, configured for a fourth demand level. FIG. 8 is a simplified schematic of one of many embodiments of a mixed mode modular cooling system according to the disclosure, configured for a fifth demand level. FIG. 9 is a simplified schematic of one of many embodiments of a mixed mode modular cooling system according to the disclosure, configured for a sixth demand level. FIG. 10 is an operating graph of one of many embodiments of a mixed mode modular cooling system according to the disclosure. FIG. 11 is a simplified schematic of another one of many embodiments of a mixed mode modular cooling system according to the disclosure, configured for a first demand level. FIG. 12 is a simplified schematic of another one of many embodiments of a mixed mode modular cooling system according to the disclosure, configured for a second demand level. FIG. 13 is a simplified schematic of another one of many embodiments of a mixed mode modular cooling system according to the disclosure, configured for a third demand level. FIG. 14 is a simplified schematic of another one of many embodiments of a mixed mode modular cooling system according to the disclosure, configured for a fourth demand level. FIG. 15 is a simplified schematic of another one of many embodiments of a mixed mode modular cooling system according to the disclosure, configured for a fifth demand level. FIG. 16 is a simplified schematic of another one of many embodiments of a mixed mode modular cooling system according to the disclosure, configured for a sixth demand level. FIGS. 1-16 are described in conjunction with one another.

In at least one embodiment, a mixed mode modular cooling system 1000 according to the disclosure can include a plurality of mixed mode refrigerant loops 100, 200, 300 and plumbing to permit a working fluid to circulate through at least a part of the loops 100, 200, 300. In at least one embodiment, each mixed mode refrigerant loop 100, 200, 300 can include its own evaporator 110, 210, 310, its own condenser 120, 220, 320, its own pump 130, 230, 330 to pump its own refrigerant through the respective evaporators 110, 210, 310 and condensers 120, 220, 320, its own compressor 130, 230, 330 to compress the respective refrigerant between the respective evaporators 110, 210, 310 and condensers 120, 220, 320, or any combination thereof. In at least one embodiment, each mixed mode refrigerant loop 100, 200, 300 can include other components, such as various control valves, expansion valves, service valves, etc.

In at least one embodiment, the plumbing can include various valves to selectively permit the working fluid to circulate, and/or prevent the working fluid from circulating, through each evaporator 110, 210, 310. In at least one embodiment, the plumbing can include one or more flow valves, such as one or more input and/or one or more output valves, to selectively permit the working fluid to flow into and/or out of the evaporators 110, 210, 310. In at least one embodiment, each loop 100, 200, 300 can include flow valves in the form of input valves without output valves, output valves without input valves, both input valves and output valves, or any combination thereof. In at least one embodiment, any loop 100, 200, 300 can include different forms or arrangements of flow valves as compared to any other loop 100, 200, 300. The plumbing and valve configurations shown in the drawings are for illustrative purposes only and show only some of many possible embodiments of the disclosure. Having multiple evaporators provides for the possibility of having numerous different configurations on the water side of the system, such as for covering any of various physical applications or implementations as appropriate under the circumstances. Embodiments of the disclosure can include any plumbing arrangement required or desired in accordance with an implementation at hand.

In at least one embodiment, the plumbing can include a first input valve 150 to selectively permit the working fluid to flow into the first evaporator 110 and/or selectively prevent the working fluid from flowing into the first evaporator 110, a second input valve 250 to selectively permit the working fluid to flow into the second evaporator 210 and/or selectively prevent the working fluid from flowing into the second evaporator 210, a third input valve 350 to selectively permit the working fluid to flow into the third evaporator 310 and/or selectively prevent the working fluid from flowing into the third evaporator 310, or any combination thereof. In at least one embodiment, the plumbing can include a first output valve 160 to selectively permit the working fluid to flow from the first evaporator 110 and/or selectively prevent the working fluid from flowing from the first evaporator 110, a second output valve 260 to selectively permit the working fluid to flow from the second evaporator 210 and/or selectively prevent the working fluid from flowing from the second evaporator 210, a third output valve 360 to selectively permit the working fluid to flow from the third evaporator 310 and/or selectively prevent the working fluid from flowing from the third evaporator 310, or any combination thereof.

In at least one embodiment, the plumbing can include a heat exchanger 400, an input manifold 410, such as between the input valves 150, 250, 350 and the heat exchanger 400, an output manifold 420, such as between the output valves 160, 260, 306 and the heat exchanger 400, or any combination thereof. By selectively trapping the working fluid in the evaporators 110, 210, 310 and/or selectively isolating each evaporator 110, 210, 310, the work necessary to circulate the working fluid through a heat exchanger 400 can be controlled. In at least one embodiment, the evaporators 110, 210, 310 can be dry-expansion evaporators.

In at least one embodiment, the system 1000 can provide flexibility to meet a wide range of cooling demands. In at least one embodiment, each mixed mode refrigerant loop 100, 200, 300 can be individually brought online and/or operated independently in either a pumped refrigerant mode or a compressed refrigerant mode, depending on the cooling demand. For example, with no, or little, demand, the heat exchanger 400 can dissipate heat, by itself, to its environment. As demand increases, any one or more of the mixed mode refrigerant loops 100, 200, 300 can be brought online in pumped refrigerant mode. As demand further increases, additional one(s) of the mixed mode refrigerant loops 100, 200, 300 can be brought online in pumped refrigerant mode and/or any one or more of the mixed mode refrigerant loops 100, 200, 300 can be switched from pumped refrigerant mode to compressed refrigerant mode.

In at least one embodiment, a first method of operating a modular cooling system according to the disclosure can include bringing individual ones of the mixed mode refrigerant loops 100, 200, 300 online in pumped refrigerant mode until all of the mixed mode refrigerant loops 100, 200, 300 are online in pumped refrigerant mode and then individually switching each of the mixed mode refrigerant loops 100, 200, 300 from pumped refrigerant mode to compressed refrigerant mode, as the demand increases. In at least one embodiment, the first method can include the reverse, i.e., individually switching each of the mixed mode refrigerant loops 100, 200, 300 from compressed refrigerant mode to pumped refrigerant mode until all of the mixed mode refrigerant loops 100, 200, 300 are in pumped refrigerant mode and then individually switching each of the mixed mode refrigerant loops 100, 200, 300 off, as the demand decreases.

In at least one embodiment, the first method can include monitoring a cooling demand, which can be determined by an analysis of any number of factors, such as one or more demand signals, such as from a thermostat and/or other temperature control system, one or more temperature setpoints, one or more working fluid temperatures, one or more environmental conditions, such as one or more air temperatures, or any combination thereof, by a controller of the cooling system, an external controller, or any combination thereof. For example, analysis of the factors can result in one or more of the loops 100, 200, 300 being isolated and/or run in pumped refrigerant mode, even where the demand signal(s) indicate a maximum cooling capacity.

In at least one embodiment, a second demand level can indicate greater cooling demand than a first demand level, a third demand level can indicate greater cooling demand than the second demand level, a fourth demand level can indicate greater cooling demand than the third demand level, and so on.

In at least one embodiment, the first method can include starting a first mixed mode refrigerant loop 100 in pumped refrigerant mode, with both the second and third mixed mode refrigerant loops 200, 300 shut down and/or isolated, as the cooling demand rises to a first demand level. In at least one embodiment, the first method can include operating the first mixed mode refrigerant loop 100 in pumped refrigerant mode and starting a second mixed mode refrigerant loop 200 in pumped refrigerant mode, with the third mixed mode refrigerant loop 300 shut down and/or isolated, as the cooling demand rises from the first demand level to a second demand level. In at least one embodiment, the first method can include operating both the first and second mixed mode refrigerant loops 100, 200 in pumped refrigerant mode and starting a third mixed mode refrigerant loop 300 in pumped refrigerant mode, as the cooling demand rises from the second demand level to a third demand level. In at least one embodiment, the first method can include operating the second and third mixed mode refrigerant loops 200, 300 in pumped refrigerant mode and switching the first mixed mode refrigerant loop 100 from pumped refrigerant mode to compressed refrigerant mode, as the cooling demand rises from the third demand level to a fourth demand level. In at least one embodiment, the first method can include operating the first mixed mode refrigerant loop 100 in compressed refrigerant mode, switching the second mixed mode refrigerant loop from pumped refrigerant mode to compressed refrigerant mode, and operating the third mixed mode refrigerant loop 300 in pumped refrigerant mode as the cooling demand rises from the fourth demand level to a fifth demand level. In at least one embodiment, the first method can include operating the first and second mixed mode refrigerant loops 100, 200 in compressed refrigerant mode and switching the third mixed mode refrigerant loop 300 from pumped refrigerant mode to compressed refrigerant mode, as the cooling demand rises from the fifth demand level to a sixth demand level.

In at least one embodiment, starting each mixed mode refrigerant loop 100, 200, 300 in pumped refrigerant mode can include opening an input valve 150, 250, 350, opening an output valve 160, 260, 360, starting a pump 140, 240, 340, pumping a that loop's two-phase refrigerant through a condenser 130, 230, 330 and an evaporator 110, 210, 310, or any combination thereof. In at least one embodiment, the two-phase refrigerant of each mixed mode refrigerant loop 100, 200, 300 is isolated and/or independent from other loops.

In at least one embodiment, switching each mixed mode refrigerant loop 100, 200, 300 from pumped refrigerant mode to compressed refrigerant mode can include leaving that loop's input valve 150, 250, 350 and/or output valve 160, 260, 360 open, stopping that loop's pump 140, 240, 340, starting that loop's compressor 130, 230, 330, compressing that loop's two-phase refrigerant between the evaporator 110, 210, 310 and the condenser 120, 220, 320, or any combination thereof.

In at least one embodiment, such as when the cooling demand varies between a first demand level and a second demand level, any one of the mixed mode refrigerant loops 100, 200, 300 can be operated in pumped refrigerant mode, while others of the mixed mode refrigerant loops 100, 200, 300 are isolated. In at least one embodiment, such as when the cooling demand varies between the second demand level and a third demand level, any two of the mixed mode refrigerant loops 100, 200, 300 can be operated in pumped refrigerant mode, while another of the mixed mode refrigerant loops 100, 200, 300 is isolated. In at least one embodiment, such as when the cooling demand varies between the third demand level and a fourth demand level, each of the mixed mode refrigerant loops 100, 200, 300 can be operated in pumped refrigerant mode. In at least one embodiment, such as when the cooling demand varies between the fourth demand level and a fifth demand level, any two of the mixed mode refrigerant loops 100, 200, 300 can be operated in pumped refrigerant mode, while another of the mixed mode refrigerant loops 100, 200, 300 is operated in compressed refrigerant mode. In at least one embodiment, such as when the cooling demand varies between the fifth demand level and a sixth demand level, any one of the mixed mode refrigerant loops 100, 200, 300 can be operated in pumped refrigerant mode, while others of the mixed mode refrigerant loops 100, 200, 300 are operated in compressed refrigerant mode. In at least one embodiment, such as when the cooling demand varies above the sixth demand level each of the mixed mode refrigerant loops 100, 200, 300 can be operated in pumped compressed mode.

In at least one embodiment, operating any of the mixed mode refrigerant loops 100, 200, 300 in pumped refrigerant mode can include circulating a working fluid through that loop's evaporator 110, 210, 310 and a heat exchanger 400, pumping that loop's refrigerant through that loop's condenser 120, 220, 320 and that loop's evaporator 110, 210, 310, rejecting heat from the heat exchanger 400 out of that loop's condenser 120, 220, 320, or any combination thereof. In at least one embodiment, isolating any of the mixed mode refrigerant loops can include trapping a portion of the working fluid in that loop's evaporator 110, 210, 310 and/or isolating that loop's evaporator 110, 210, 310 from the heat exchanger 400. In at least one embodiment, operating any of the mixed mode refrigerant loops 100, 200, 300 in compressed refrigerant mode can include circulating a working fluid through that loop's evaporator 110, 210, 310 and a heat exchanger 400, compressing that loop's refrigerant between that loop's evaporator 110, 210, 310 and that loop's condenser 120, 220, 320, thereby rejecting heat from the heat exchanger 400 out of that loop's condenser 120, 220, 320.

In at least one embodiment, each pump 140, 240, 340 and/or each compressor 130, 230, 330 can be run at its maximum rated speed or any variable speed between zero and its maximum rated speed. In at least one embodiment, such as when the cooling demand varies between the first demand level and the second demand level, any one pump 140, 240, 340 can be run at a variable speed. In at least one embodiment, such as when the cooling demand varies between the second demand level and the third demand level, any one pump 140, 240, 340 can be run at its maximum rated speed while another pump 140, 240, 340 can be run at a variable speed. In at least one embodiment, such as when the cooling demand varies between the third demand level and the fourth demand level, any two pumps 140, 240, 340 can be run at their maximum rated speeds while another pump 140, 240, 340 can be run at a variable speed. In at least one embodiment, such as when the cooling demand varies between the fourth demand level and the fifth demand level, any two pumps 140, 240, 340 can be run at their maximum rated speeds while the other compressor 130, 230, 330 can be run at a variable speed. In at least one embodiment, such as when the cooling demand varies between the fifth demand level and the sixth demand level, any one pump 140, 240, 340 can be run at its maximum rated speed while one of the other compressors 130, 230, 330 can be run at its maximum rated speed and another one of the other compressors 130, 230, 330 can be run at a variable speed. In at least one embodiment, such as when the cooling demand varies above the sixth demand level, any two of the compressors 130, 230, 330 can be run at its maximum rated speed and another of the other compressors 130, 230, 330 can be run at a variable speed.

In at least one embodiment, when the cooling demand varies, any pump 140, 240, 340 can be run at a variable speed, any compressor 130, 230, 330 can be run at a variable speed, any fan 170, 270, 370 can be run at a variable speed, or any combination thereof. In at least one embodiment, any pump 140, 240, 340 can be run at a variable speed, any compressor 130, 230, 330 can be run at a variable speed, any fan 170, 270, 370 can be run at a variable speed, or any combination thereof, such as to maintain saturation conditions of the refrigerant at the evaporator outlet.

In at least one embodiment, any or each of the mixed mode refrigerant loops 100, 200, 300 can have the same cooling capacity in pumped refrigerant mode and/or compressed refrigerant mode. In at least one embodiment, any or each of the mixed mode refrigerant loops 100, 200, 300 can have different cooling capacities in pumped refrigerant mode and/or compressed refrigerant mode. For example, a second mixed mode refrigerant loop 200 can have twice the cooling capacity of a first mixed mode refrigerant loop 100, and/or a third mixed mode refrigerant loop 300 can have the same or greater, such as twice, cooling capacity of both the first and second mixed mode refrigerant loops 100, 200 combined. Thus, different ones of the mixed mode refrigerant loops 100, 200, 300 can be switched on and off and/or switched between pumped refrigerant mode and compressed refrigerant mode, as needed, to meet the cooling demand.

In at least one embodiment, a second method of operating a modular cooling system according to the disclosure can include bringing individual ones of the mixed mode refrigerant loops 100, 200, 300 online in pumped refrigerant mode and then switching that mixed mode refrigerant loop 100, 200, 300 from pumped refrigerant mode to compressed refrigerant mode before bringing the next mixed mode refrigerant loop 100, 200, 300 online in pumped refrigerant mode, as the demand increases. In at least one embodiment, the second method can include the reverse, i.e., switching one of the mixed mode refrigerant loops 100, 200, 300 from compressed refrigerant mode to pumped refrigerant mode and then switching that one of the mixed mode refrigerant loops 100, 200, 300 off before switching the next one of the mixed mode refrigerant loops 100, 200, 300 from compressed refrigerant mode to pumped refrigerant mode until all of the mixed mode refrigerant loops 100, 200, 300 off, as the demand decreases.

In at least one embodiment, the second method can include monitoring a cooling demand. In at least one embodiment, the second method can include starting a first mixed mode refrigerant loop 100 in pumped refrigerant mode, with both the second and third mixed mode refrigerant loops 200, 300 shut down and/or isolated, as the cooling demand rises to a first demand level. In at least one embodiment, the second method can include switching the first mixed mode refrigerant loop 100 from pumped refrigerant mode to compressed refrigerant mode, as the cooling demand rises from the first demand level to a second demand level. In at least one embodiment, the second method can include operating the first mixed mode refrigerant loop 100 in compressed refrigerant mode and/or starting a second mixed mode refrigerant loop 200 in pumped refrigerant mode, as the cooling demand rises from the second demand level to a third demand level. In at least one embodiment, the second method can include operating the first mixed mode refrigerant loop 100 in compressed refrigerant mode and/or switching the second mixed mode refrigerant loop 200 from pumped refrigerant mode to compressed refrigerant mode, as the cooling demand rises from the third demand level to a fourth demand level. In at least one embodiment, the second method can include operating the first and second mixed mode refrigerant loops 100, 200 in compressed refrigerant mode and/or starting a third mixed mode refrigerant loop 300 in pumped refrigerant mode, as the cooling demand rises from the fourth demand level to a fifth demand level. In at least one embodiment, the second method can include operating the first and second mixed mode refrigerant loops 100, 200 in compressed refrigerant mode and/or switching the third mixed mode refrigerant loop 300 from pumped refrigerant mode to compressed refrigerant mode, as the cooling demand rises from the fifth demand level to a sixth demand level.

In at least one embodiment, as the cooling demand varies between the first demand level and the second demand level, a first pump speed of a first pump 140 of the first mixed mode refrigerant loop 100 can be varied. In at least one embodiment, as the cooling demand varies between the second demand level and the third demand level, a first compressor speed of a first compressor 130 of the first mixed mode refrigerant loop 100 can be varied.

In at least one embodiment, as the cooling demand varies between the third demand level and the fourth demand level, the first compressor 130 can be run at its maximum rated speed and/or a second pump speed of a second pump 240 of the second mixed mode refrigerant loop 200 can be varied. In at least one embodiment, as the cooling demand varies between the third demand level and the fourth demand level, the first compressor speed of the first compressor 130 can be varied and/or the second pump 240 can be run at its maximum rated speed.

In at least one embodiment, as the cooling demand varies between the fourth demand level and the fifth demand level, the first compressor 130 can be run at its maximum rated speed and/or a second compressor speed of a second compressor 230 can be varied. In at least one embodiment, as the cooling demand varies between the fourth demand level and the fifth demand level, the first compressor speed of the first compressor 130 can be varied and/or the second compressor 230 can be run at its maximum rated speed.

In at least one embodiment, as the cooling demand varies between the fifth demand level and the sixth demand level, the first and/or the second compressor 130 can be run at their maximum rated speed and/or a third pump speed of a third pump 340 of the third mixed mode refrigerant loop 300 can be varied. In at least one embodiment, as the cooling demand varies between the fifth demand level and the sixth demand level, the speed of the first and/or second compressor 130, 230 can be varied and/or the third pump 340 can be run at its maximum rated speed.

In at least one embodiment, as the cooling demand varies above the sixth demand level, any of the compressors 130, 230, 330 can be run at their maximum rated speed while the speed(s) of others of the compressors 130, 230, 330 is varied. In at least one embodiment, as the cooling demand varies above the sixth demand level, the speeds of each of the compressors 130, 230, 330 can be varied.

In at least one embodiment, such as when the cooling demand varies between a first demand level and a second demand level, any one of the mixed mode refrigerant loops 100, 200, 300 can be operated in pumped refrigerant mode, while isolating others of the mixed mode refrigerant loops 100, 200, 300. In at least one embodiment, such as when the cooling demand varies between the second demand level and a third demand level, any one of the mixed mode refrigerant loops 100, 200, 300 can be operated in compressed refrigerant mode, while isolating others of the mixed mode refrigerant loops 100, 200, 300. In at least one embodiment, such as when the cooling demand varies between the third demand level and a fourth demand level, any one of the mixed mode refrigerant loops 100, 200, 300 can be operated in compressed refrigerant mode and any other one of the mixed mode refrigerant loops 100, 200, 300 can be operated in pumped refrigerant mode, while isolating any remaining mixed mode refrigerant loops 100, 200, 300. In at least one embodiment, such as when the cooling demand varies between the fourth demand level and a fifth demand level, any two of the mixed mode refrigerant loops 100, 200, 300 can be operated in compressed refrigerant mode, while isolating any remaining mixed mode refrigerant loops 100, 200, 300. In at least one embodiment, such as when the cooling demand varies between the fifth demand level and a sixth demand level, any two of the mixed mode refrigerant loops 100, 200, 300 can be operated in compressed refrigerant mode and another one of the mixed mode refrigerant loops 100, 200, 300 can be operated in pumped refrigerant mode. In at least one embodiment, such as when the cooling demand varies above the sixth demand level, each of the mixed mode refrigerant loops 100, 200, 300 can be operated in compressed refrigerant mode.

In at least one embodiment, a method of operating a modular cooling system can include operating a mixed mode refrigerant loop 100 in compressed refrigerant mode, operating another mixed mode refrigerant loop 200 in pumped refrigerant mode, and monitoring a cooling demand. In at least one embodiment, a method of operating a modular cooling system can include operating the mixed mode refrigerant loop 100 in compressed refrigerant mode and switching the mixed mode refrigerant loop 200 from pumped refrigerant mode to compressed refrigerant mode, as the cooling demand rises. In at least one embodiment, a method of operating a modular cooling system can include operating the mixed mode refrigerant loop 200 in pumped refrigerant mode and switching the mixed mode refrigerant loop 100 from compressed refrigerant mode to pumped refrigerant mode, as the cooling demand falls.

In some instances, one or more mixed mode refrigerant loops, demand loads, cooling modes, or other aspects of the disclosure are referred to herein as "first," "second" (and so on); similarly, exemplary embodiments of the disclosure discussed herein include embodiments having, e.g., two mixed modes or four mixed modes. It should be understood that such terminology is for convenience of reference and/or illustrative purposes and not for purposes of limitation. Rather, embodiments of the disclosure can include any number of mixed mode refrigerant loops and cooling modes required or desired according to a given physical implementation. For example, in at least one embodiment, systems and methods according to the disclosure can include n mixed mode refrigerant loops and/or cooling modes, wherein n can be any number greater than or equal to 1 (any one of which can be referred to as the "first," "second" or via another relational term, unless otherwise indicated). Similarly, the control methodology disclosed herein includes but some examples of many. The various method steps can be combined with one another and/or with other method steps as required or desired for an implementation of the disclosure, such as for optimizing system operation under the applicable conditions or circumstances.

In at least one embodiment, a method of operating a modular cooling system can include monitoring a cooling demand, starting a first mixed mode refrigerant loop in pumped refrigerant mode as the cooling demand rises to a first demand level, operating the first mixed mode refrigerant loop in pumped refrigerant mode and starting a second mixed mode refrigerant loop in pumped refrigerant mode as the cooling demand rises from the first demand level to a second demand level, operating the second mixed mode refrigerant loop in pumped refrigerant mode and switching the first mixed mode refrigerant loop from pumped refrigerant mode to compressed refrigerant mode as the cooling demand rises from the second demand level to a third demand level, operating the first mixed mode refrigerant loop in compressed refrigerant mode and switching the second mixed mode refrigerant loop from pumped refrigerant mode to compressed refrigerant mode as the cooling demand rises from the third demand level to a fourth demand level, or any combination thereof.

In at least one embodiment, starting the first mixed mode refrigerant loop in pumped refrigerant mode can include opening a first flow valve, starting a first pump, pumping a first two-phase refrigerant through a first condenser and a first evaporator, or any combination thereof. In at least one embodiment, starting the second mixed mode refrigerant loop in pumped refrigerant mode can include opening a second flow valve, starting a second pump, pumping a second two-phase refrigerant through a second condenser and a second evaporator, or any combination thereof.

In at least one embodiment, switching the first mixed mode refrigerant loop from pumped refrigerant mode to compressed refrigerant mode can include leaving the first flow valve open, stopping the first pump, starting a first compressor, compressing the first two-phase refrigerant between the first evaporator and the first condenser, or any combination thereof. In at least one embodiment, switching the second mixed mode refrigerant loop from pumped refrigerant mode to compressed refrigerant mode can include leaving the second flow valve open, stopping the second pump, starting a second compressor, compressing the second two-phase refrigerant between the second evaporator and the second condenser, or any combination thereof.

In at least one embodiment, the second demand level can indicate greater cooling demand than the first demand level. In at least one embodiment, the third demand level can indicate greater cooling demand than the second demand level. In at least one embodiment, the fourth demand level can indicate greater cooling demand than the third demand level.

In at least one embodiment, a method of operating a modular cooling system can include, such as when the cooling demand varies between the first demand level and the second demand level, varying a first pump speed of a first pump of the first mixed mode refrigerant loop. In at least one embodiment, a method of operating a modular cooling system can include, such as when the cooling demand varies between the second demand level and the third demand level, running the first pump at its maximum rated speed and/or varying a second pump speed of a second pump of the second mixed mode refrigerant loop.

In at least one embodiment, a method of operating a modular cooling system can include, such as when the cooling demand varies between the third demand level and the fourth demand level, running the second pump at its maximum rated speed and/or varying a first compressor speed of a first compressor of the first mixed mode refrigerant loop. In at least one embodiment, a method of operating a modular cooling system can include, such as when the cooling demand varies between the third demand level and the fourth demand level, running a first compressor of the first mixed mode refrigerant loop at its maximum compressor speed and/or varying the second pump speed of the second pump.

In at least one embodiment, a method of operating a modular cooling system can include, such as when the cooling demand varies above the fourth demand level, running the first compressor at its maximum compressor speed and/or varying a second compressor speed of a second compressor of the second mixed mode refrigerant loop. In at least one embodiment, a method of operating a modular cooling system can include, such as when the cooling demand varies above the fourth demand level, varying the first compressor speed and/or running a second compressor at its maximum compressor speed.

In at least one embodiment, the first mixed mode refrigerant loop and the second mixed mode refrigerant loop have the same or different cooling capacities in pumped refrigerant mode. In at least one embodiment, the first mixed mode refrigerant loop and the second mixed mode refrigerant loop have the same or different cooling capacities in compressed refrigerant mode.

In at least one embodiment, a method of operating a modular cooling system can include monitoring a cooling demand. In at least one embodiment, a method of operating a modular cooling system can include, such as when the cooling demand varies between a first demand level and a second demand level, operating a first mixed mode refrigerant loop in pumped refrigerant mode, while isolating a second mixed mode refrigerant loop. In at least one embodiment, a method of operating a modular cooling system can include, such as when the cooling demand varies between the second demand level and a third demand level, operating both the first mixed mode refrigerant loop and the second mixed mode refrigerant loop in pumped refrigerant mode. In at least one embodiment, a method of operating a modular cooling system can include, such as when the cooling demand varies between the third demand level and a fourth demand level, operating the first mixed mode refrigerant loop in compressed refrigerant mode and the second mixed mode refrigerant loop in pumped refrigerant mode. In at least one embodiment, a method of operating a modular cooling system can include, such as when the cooling demand varies above the fourth demand level, operating both the first mixed mode refrigerant loop and the second mixed mode refrigerant loop in compressed refrigerant mode.

In at least one embodiment, operating the first mixed mode refrigerant loop in pumped refrigerant mode can include circulating a working fluid through a first evaporator of the first mixed mode refrigerant loop and a heat exchanger, pumping a first refrigerant through a first condenser of the first mixed mode refrigerant loop and the first evaporator, rejecting heat from the heat exchanger out of the first condenser, or any combination thereof. In at least one embodiment, isolating the second mixed mode refrigerant loop can include trapping a portion of the working fluid in a second evaporator of the second mixed mode refrigerant loop and/or isolating the second evaporator from the heat exchanger.

In at least one embodiment, operating both the first mixed mode refrigerant loop and the second mixed mode refrigerant loop in pumped refrigerant mode can include circulating a working fluid through a first evaporator of the first mixed mode refrigerant loop, a second evaporator of the second mixed mode refrigerant loop, and a heat exchanger. In at least one embodiment, operating both the first mixed mode refrigerant loop and the second mixed mode refrigerant loop in pumped refrigerant mode can include pumping a first refrigerant through a first condenser of the first mixed mode refrigerant loop and the first evaporator, thereby rejecting heat from the heat exchanger out of the first condenser. In at least one embodiment, operating both the first mixed mode refrigerant loop and the second mixed mode refrigerant loop in pumped refrigerant mode can include pumping a second refrigerant through a second condenser of the second mixed mode refrigerant loop and the second evaporator, thereby rejecting heat from the heat exchanger out of the second condenser.

In at least one embodiment, operating the first mixed mode refrigerant loop in compressed refrigerant mode and the second mixed mode refrigerant loop in pumped refrigerant mode can include circulating a working fluid through a first evaporator of the first mixed mode refrigerant loop, a second evaporator of the second mixed mode refrigerant loop, and a heat exchanger. In at least one embodiment, operating the first mixed mode refrigerant loop in compressed refrigerant mode and the second mixed mode refrigerant loop in pumped refrigerant mode can include compressing a first refrigerant between the first evaporator and a first condenser of the first mixed mode refrigerant loop, thereby rejecting heat from the heat exchanger out of the first condenser. In at least one embodiment, operating the first mixed mode refrigerant loop in compressed refrigerant mode and the second mixed mode refrigerant loop in pumped refrigerant mode can include pumping a second refrigerant through a second condenser of the second mixed mode refrigerant loop and the second evaporator, thereby rejecting heat from the heat exchanger out of the second condenser.

In at least one embodiment, operating both the first mixed mode refrigerant loop and the second mixed mode refrigerant loop in compressed refrigerant mode can include circulating a working fluid through a first evaporator of the first mixed mode refrigerant loop, a second evaporator of the second mixed mode refrigerant loop, and a heat exchanger. In at least one embodiment, operating both the first mixed mode refrigerant loop and the second mixed mode refrigerant loop in compressed refrigerant mode can include compressing a first refrigerant between the first evaporator and a first condenser of the first mixed mode refrigerant loop, thereby rejecting heat from the heat exchanger out of the first condenser. In at least one embodiment, operating both the first mixed mode refrigerant loop and the second mixed mode refrigerant loop in compressed refrigerant mode can include compressing a second refrigerant between the second evaporator and a second condenser of the second mixed mode refrigerant loop, thereby rejecting heat from the heat exchanger out of the second condenser.

In at least one embodiment, a mixed mode modular cooling system can include a first mixed mode refrigerant loop, a second mixed mode refrigerant loop, and plumbing to permit a working fluid to circulate through at least a portion of the loops. In at least one embodiment, the first mixed mode refrigerant loop can include a first evaporator, a first condenser, a first pump to pump a first refrigerant through the first evaporator and the first condenser, a first compressor to compress the first refrigerant between the first evaporator and the first condenser, or any combination thereof. In at least one embodiment, the second mixed mode refrigerant loop can include a second evaporator, a second condenser, a second pump to pump a second refrigerant through the second evaporator and the second condenser, a second compressor to compress the second refrigerant between the second evaporator and the second condenser, or any combination thereof. In at least one embodiment, the plumbing can permit a working fluid to circulate through a heat exchanger, the first evaporator, the second evaporator, or any combination thereof.

In at least one embodiment, the plumbing can include a first valve to selectively permit the working fluid to circulate through the first evaporator and/or a second valve to selectively permit the working fluid to circulate through the second evaporator. In at least one embodiment, the plumbing can include a first input valve to selectively permit the working fluid to flow into the first evaporator and selectively prevent the working fluid from flowing into the first evaporator and/or a first output valve to selectively permit the working fluid to flow out of the first evaporator and selectively prevent the working fluid from flowing from the first evaporator, a second input valve to selectively permit the working fluid to flow into the second evaporator and selectively prevent the working fluid from flowing into the second evaporator and/or a second output valve to selectively permit the working fluid to flow out of the second evaporator and selectively prevent the working fluid from flowing from the second evaporator, or any combination thereof. In at least one embodiment, the plumbing can include an input manifold, such as between the first and second evaporator and/or input valves and the heat exchanger, and/or an output manifold, such as between the first and second evaporators and/or output valves and the heat exchanger.

In at least one embodiment, a method of operating a modular cooling system can include monitoring a cooling demand. In at least one embodiment, a method of operating a modular cooling system can include starting a first mixed mode refrigerant loop in pumped refrigerant mode, such as when the cooling demand rises to a first demand level. In at least one embodiment, a method of operating a modular cooling system can include switching the first mixed mode refrigerant loop from pumped refrigerant mode to compressed refrigerant mode, such as when the cooling demand rises from the first demand level to a second demand level. In at least one embodiment, a method of operating a modular cooling system can include operating the first mixed mode refrigerant loop in compressed refrigerant mode and/or starting a second mixed mode refrigerant loop in pumped refrigerant mode, such as when the cooling demand rises from the second demand level to a third demand level. In at least one embodiment, a method of operating a modular cooling system can include operating the first mixed mode refrigerant loop in compressed refrigerant mode and/or switching the second mixed mode refrigerant loop from pumped refrigerant mode to compressed refrigerant mode, such as when the cooling demand rises from the third demand level to a fourth demand level.

In at least one embodiment, a method of operating a modular cooling system can include, such as when the cooling demand varies between the first demand level and the second demand level, varying a first pump speed of a first pump of the first mixed mode refrigerant loop. In at least one embodiment, a method of operating a modular cooling system can include, such as when the cooling demand varies between the second demand level and the third demand level, varying a first compressor speed of a first compressor of the first mixed mode refrigerant loop.

In at least one embodiment, a method of operating a modular cooling system can include, such as when the cooling demand varies between the third demand level and the fourth demand level, running the first compressor at its maximum rated speed and/or varying a second pump speed of a second pump of the second mixed mode refrigerant loop. In at least one embodiment, a method of operating a modular cooling system can include, such as when the cooling demand varies between the third demand level and the fourth demand level, varying the first compressor speed and/or running the second pump at its maximum rated speed.

In at least one embodiment, a method of operating a modular cooling system can include, such as when the cooling demand varies above the fourth demand level, running the first compressor at its maximum rated speed and/or varying a second compressor speed of a second compressor of the second mixed mode refrigerant loop. In at least one embodiment, a method of operating a modular cooling system can include, such as when the cooling demand varies above the fourth demand level, varying the first compressor speed and/or running the second compressor at its maximum rated speed.

In at least one embodiment, a method of operating a modular cooling system can include monitoring a cooling demand. In at least one embodiment, a method of operating a modular cooling system can include, such as when the cooling demand varies between a first demand level and a second demand level, operating a first mixed mode refrigerant loop in pumped refrigerant mode, while isolating a second mixed mode refrigerant loop. In at least one embodiment, a method of operating a modular cooling system can include, such as when the cooling demand varies between the second demand level and a third demand level, operating the first mixed mode refrigerant loop in compressed refrigerant mode, while isolating the second mixed mode refrigerant loop. In at least one embodiment, a method of operating a modular cooling system can include, such as when the cooling demand varies between the third demand level and a fourth demand level, operating the first mixed mode refrigerant loop in compressed refrigerant mode and the second mixed mode refrigerant loop in pumped refrigerant mode. In at least one embodiment, a method of operating a modular cooling system can include, such as when the cooling demand varies above the fourth demand level, operating both the first mixed mode refrigerant loop and the second mixed mode refrigerant loop in compressed refrigerant mode.

In at least one embodiment, a method of operating a modular cooling system can include operating a first mixed mode refrigerant loop in compressed refrigerant mode, operating a second mixed mode refrigerant loop in pumped refrigerant mode, and monitoring a cooling demand. In at least one embodiment, a method of operating a modular cooling system can include operating the first mixed mode refrigerant loop in compressed refrigerant mode and switching the second mixed mode refrigerant loop from pumped refrigerant mode to compressed refrigerant mode, as the cooling demand rises. In at least one embodiment, a method of operating a modular cooling system can include operating the second mixed mode refrigerant loop in pumped refrigerant mode and switching the first mixed mode refrigerant loop from compressed refrigerant mode to pumped refrigerant mode, as the cooling demand falls. Embodiments of the disclosure can include any number of mixed mode refrigerant loops and cooling modes required or desired according to a given physical implementation.

In at least one embodiment, a non-transitory computer readable media can have instructions stored thereon that, when executed by a processor, cause the processor to perform and/or cause the performance of any one or more of the methods and/or method steps shown and/or described herein. As will be appreciated by those skilled in the art having the benefits of the present disclosure, aspects of one or more embodiments of the disclosure can be embodied as a system, method or computer program product. Accordingly, aspects of the present embodiments can take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present disclosure may take the form of a computer program product embodied in one or more non-transitory computer readable medium(s) having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to embodiments of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.
The disclosure comprises the following items:
1. A method of operating a modular cooling system comprising:
   monitoring a cooling demand;
   starting a first mixed mode refrigerant loop in pumped refrigerant mode, as the cooling demand rises to a first demand level;
   operating the first mixed mode refrigerant loop in pumped refrigerant mode and starting a second mixed mode refrigerant loop in pumped refrigerant mode, as the cooling demand rises from the first demand level to a second demand level;
   operating the second mixed mode refrigerant loop in pumped refrigerant mode and switching the first mixed mode refrigerant loop from pumped refrigerant mode to compressed refrigerant mode, as the cooling demand rises from the second demand level to a third demand level; and
   operating the first mixed mode refrigerant loop in compressed refrigerant mode and switching the second mixed mode refrigerant loop from pumped refrigerant mode to compressed refrigerant mode, as the cooling demand rises from the third demand level to a fourth demand level.
2. The method of item 1, wherein starting the first mixed mode refrigerant loop in pumped refrigerant mode comprises:
   opening a first flow valve; and
   starting a first pump, thereby pumping a first two-phase refrigerant through a first condenser and a first evaporator.
3. The method of item 1 or item 2, wherein starting the second mixed mode refrigerant loop in pumped refrigerant mode comprises:
   opening a second flow valve; and
   starting a second pump, thereby pumping a second two-phase refrigerant through a second condenser and a second evaporator.
4. The method of any preceding item, wherein switching the first mixed mode refrigerant loop from pumped refrigerant mode to compressed refrigerant mode comprises
   leaving the first flow valve open;
   stopping the first pump; and
   starting a first compressor, thereby compressing the first two-phase refrigerant between the first evaporator and the first condenser.
5. The method of any preceding item, wherein switching the second mixed mode refrigerant loop from pumped refrigerant mode to compressed refrigerant mode comprises
   leaving the second flow valve open;
   stopping the second pump; and
   starting a second compressor, thereby compressing the second two-phase refrigerant between the second evaporator and the second condenser.
6. The method of any preceding item, further comprising, as the cooling demand varies between the first demand level and the second demand level, varying a first pump speed of a first pump of the first mixed mode refrigerant loop; wherein the second demand level indicates greater cooling demand than the first demand level; wherein the third demand level indicates greater cooling demand than the second demand level; and wherein the fourth demand level indicates greater cooling demand than the third demand level.
7. The method of any preceding item, further comprising, as the cooling demand varies between the second demand level and the third demand level;
   running the first pump at a first maximum pump speed, wherein the first maximum pump speed is the first pump's maximum rated speed; and
   varying a second pump speed of a second pump of the second mixed mode refrigerant loop.
8. The method of any preceding item, further comprising, as the cooling demand varies between the third demand level and the fourth demand level;
   running the second pump at a second maximum pump speed, wherein the second maximum pump speed is the second pump's maximum rated speed; and
   varying a first compressor speed of a first compressor of the first mixed mode refrigerant loop.
9. The method of any preceding item, further comprising, as the cooling demand varies between the third demand level and the fourth demand level;
   running a first compressor of the first mixed mode refrigerant loop at a first maximum compressor speed, wherein the first maximum compressor speed is the first compressor's maximum rated speed; and
   varying the second pump speed of the second pump.
10. The method of any preceding item, further comprising, as the cooling demand varies above the fourth demand level;
   running the first compressor at the first maximum compressor speed; and
   varying a second compressor speed of a second compressor of the second mixed mode refrigerant loop.
11. A method of operating a modular cooling system comprising:
   monitoring a cooling demand;
   operating, as the cooling demand varies between a first demand level and a second demand level, a first mixed mode refrigerant loop in pumped refrigerant mode, while isolating a second mixed mode refrigerant loop;
   operating, as the cooling demand varies between the second demand level and a third demand level, both the first mixed mode refrigerant loop and the second mixed mode refrigerant loop in pumped refrigerant mode;
   operating, as the cooling demand varies between the third demand level and a fourth demand level, the first mixed mode refrigerant loop in compressed refrigerant mode and the second mixed mode refrigerant loop in pumped refrigerant mode; and
   operating, as the cooling demand varies above the fourth demand level, both the first mixed mode refrigerant loop and the second mixed mode refrigerant loop in compressed refrigerant mode.
12. The method of item 11, wherein operating the first mixed mode refrigerant loop in pumped refrigerant mode comprises:
   circulating a working fluid through a first evaporator of the first mixed mode refrigerant loop and a heat exchanger; and pumping a first refrigerant through a first condenser of the first mixed mode refrigerant loop and the first evaporator, thereby rejecting heat from the heat exchanger out of the first condenser.
13. The method of item 11 or item 12, wherein isolating the second mixed mode refrigerant loop comprises trapping a portion of the working fluid in a second evaporator of the second mixed mode refrigerant loop and isolating the second evaporator from the heat exchanger.
14. The method of any of items 11-13, wherein operating both the first mixed mode refrigerant loop and the second mixed mode refrigerant loop in pumped refrigerant mode comprises
   circulating a working fluid through a first evaporator of the first mixed mode refrigerant loop, a second evaporator of the second mixed mode refrigerant loop, and a heat exchanger;
   pumping a first refrigerant through a first condenser of the first mixed mode refrigerant loop and the first evaporator, thereby rejecting heat from the heat exchanger out of the first condenser; and
   pumping a second refrigerant through a second condenser of the second mixed mode refrigerant loop and the second evaporator, thereby rejecting heat from the heat exchanger out of the second condenser.
15. The method of any of items 11-14, wherein operating the first mixed mode refrigerant loop in compressed refrigerant mode and the second mixed mode refrigerant loop in pumped refrigerant mode comprises
   circulating a working fluid through a first evaporator of the first mixed mode refrigerant loop, a second evaporator of the second mixed mode refrigerant loop, and a heat exchanger;
   compressing a first refrigerant between the first evaporator and a first condenser of the first mixed mode refrigerant loop, thereby rejecting heat from the heat exchanger out of the first condenser; and
   pumping a second refrigerant through a second condenser of the second mixed mode refrigerant loop and the second evaporator, thereby rejecting heat from the heat exchanger out of the second condenser.
16. The method of any of items 11-15, wherein operating both the first mixed mode refrigerant loop and the second mixed mode refrigerant loop in compressed refrigerant mode comprises
   circulating a working fluid through a first evaporator of the first mixed mode refrigerant loop, a second evaporator of the second mixed mode refrigerant loop, and a heat exchanger;
   compressing a first refrigerant between the first evaporator and a first condenser of the first mixed mode refrigerant loop, thereby rejecting heat from the heat exchanger out of the first condenser; and
   compressing a second refrigerant between the second evaporator and a second condenser of the second mixed mode refrigerant loop, thereby rejecting heat from the heat exchanger out of the second condenser.
17. A mixed mode modular cooling system comprising:
   a first mixed mode refrigerant loop including a first evaporator, a first condenser, a first pump configured to selectively pump a first refrigerant through the first evaporator and the first condenser, and a first compressor configured to selectively compress the first refrigerant between the first evaporator and the first condenser;
   a second mixed mode refrigerant loop including a second evaporator, a second condenser, a second pump configured to selectively pump a second refrigerant through the second evaporator and the second condenser, and a second compressor configured to selectively compress the second refrigerant between the second evaporator and the second condenser; and
   plumbing configured to permit a working fluid to circulate through a heat exchanger, the first evaporator, and the second evaporator.
18. The system of item 17, wherein the plumbing further comprises:
   a first valve configured to selectively permit the working fluid to circulate through the first evaporator; and
   a second valve configured to selectively permit the working fluid to circulate through the second evaporator.
19. The system of item 17 or item 18, wherein the plumbing further comprises:
   a first output valve configured to selectively permit the working fluid to flow out of the first evaporator and selectively prevent the working fluid from flowing from the first evaporator; and
   a second output valve configured to selectively permit the working fluid to flow out of the second evaporator and selectively prevent the working fluid from flowing from the second evaporator.
20. The system of any of items 17-19, wherein the plumbing further comprises:
   an input manifold disposed fluidically between the first and second evaporators, and the heat exchanger, respectively; and
   an output manifold disposed fluidically between the first and second output valves, and the heat exchanger, respectively.

A1. A method of operating a modular cooling system comprising:
   monitoring a cooling demand;
   starting a first mixed mode refrigerant loop in pumped refrigerant mode, as the cooling demand rises to a first demand level;
   operating the first mixed mode refrigerant loop in pumped refrigerant mode and starting a second mixed mode refrigerant loop in pumped refrigerant mode, as the cooling demand rises from the first demand level to a second demand level;
   operating the second mixed mode refrigerant loop in pumped refrigerant mode and switching the first mixed mode refrigerant loop from pumped refrigerant mode to compressed refrigerant mode, as the cooling demand rises from the second demand level to a third demand level; and
   operating the first mixed mode refrigerant loop in compressed refrigerant mode and switching the second mixed mode refrigerant loop from pumped refrigerant mode to compressed refrigerant mode, as the cooling demand rises from the third demand level to a fourth demand level.
A2. The method of item A1, wherein starting the first mixed mode refrigerant loop in pumped refrigerant mode comprises:
   opening a first flow valve; and
   starting a first pump, thereby pumping a first two-phase refrigerant through a first
   condenser and a first evaporator.
A3. The method of item A1 or item A2, wherein starting the second mixed mode refrigerant loop in pumped refrigerant mode comprises:
   opening a second flow valve; and
   starting a second pump, thereby pumping a second two-phase refrigerant through a
   second condenser and a second evaporator.
A4. The method of any of items A1-A3, wherein switching the first mixed mode refrigerant loop from pumped refrigerant mode to compressed refrigerant mode comprises
   leaving the first flow valve open;
   stopping the first pump; and
   starting a first compressor, thereby compressing the first two-phase refrigerant between
   the first evaporator and the first condenser.
A5. The method of any of items A1-A4, wherein switching the second mixed mode refrigerant loop from pumped refrigerant mode to compressed refrigerant mode comprises
   leaving the second flow valve open;
   stopping the second pump; and
   starting a second compressor, thereby compressing the second two-phase refrigerant
   between the second evaporator and the second condenser.
A6. The method of any of items A1-A5, wherein the second demand level indicates greater cooling demand than the first demand level, wherein the third demand level indicates greater cooling demand than the second demand level, and wherein the fourth demand level indicates greater cooling demand than the third demand level.
A7. The method of any of items A1-A6, further comprising, as the cooling demand varies between the first demand level and the second demand level, varying a first pump speed of a first pump of the first mixed mode refrigerant loop.
A8. The method of any of items A1-A7, further comprising, as the cooling demand varies between the second demand level and the third demand level;
   running the first pump at a first maximum pump speed, wherein the first maximum pump speed is the first pump's maximum rated speed; and
   varying a second pump speed of a second pump of the second mixed mode refrigerant loop.
A9. The method of any of items A1-A8, further comprising, as the cooling demand varies between the third demand level and the fourth demand level;
   running the second pump at a second maximum pump speed, wherein the second maximum pump speed is the second pump's maximum rated speed; and
   varying a first compressor speed of a first compressor of the first mixed mode refrigerant loop.
A10. The method of any of items A1-A9, further comprising, as the cooling demand varies between the third demand level and the fourth demand level;
   running a first compressor of the first mixed mode refrigerant loop at a first maximum compressor speed, wherein the first maximum compressor speed is the first compressor's maximum rated speed; and
   varying the second pump speed of the second pump.
A11. The method of any of items A1-A10, further comprising, as the cooling demand varies above the fourth demand level;
   running the first compressor at the first maximum compressor speed; and
   varying a second compressor speed of a second compressor of the second mixed mode
   refrigerant loop.
A12. The method of any of items A1-A11, wherein the first mixed mode refrigerant loop and the second mixed mode refrigerant loop have the same cooling capacity in pumped refrigerant mode.
A13. The method of any of items A1-A12, wherein the first mixed mode refrigerant loop and the second mixed mode refrigerant loop have different cooling capacities in pumped refrigerant mode.
A14. The method of any of items A1-A13, wherein the first mixed mode refrigerant loop and the second mixed mode refrigerant loop have the same cooling capacity in compressed refrigerant mode.
A15. The method of any of items A1-A14, wherein the first mixed mode refrigerant loop and the second mixed mode refrigerant loop have different cooling capacities in compressed refrigerant mode.
A16. A method of operating a modular cooling system comprising:
   monitoring a cooling demand;
   operating, as the cooling demand varies between a first demand level and a second demand level, a first mixed mode refrigerant loop in pumped refrigerant mode, while isolating a second mixed mode refrigerant loop;
   operating, as the cooling demand varies between the second demand level and a third demand level, both the first mixed mode refrigerant loop and the second mixed mode refrigerant loop in pumped refrigerant mode;
   operating, as the cooling demand varies between the third demand level and a fourth demand level, the first mixed mode refrigerant loop in compressed refrigerant mode and the second mixed mode refrigerant loop in pumped refrigerant mode; and
   operating, as the cooling demand varies above the fourth demand level, both the first mixed mode refrigerant loop and the second mixed mode refrigerant loop in compressed refrigerant mode.
   A17. The method of item A16, wherein operating the first mixed mode refrigerant loop in pumped refrigerant mode comprises:
      circulating a working fluid through a first evaporator of the first mixed mode refrigerant loop and a heat exchanger; and
      pumping a first refrigerant through a first condenser of the first mixed mode refrigerant loop and the first evaporator, thereby rejecting heat from the heat exchanger out of the first condenser.
A18. The method of item A16 or item A17, wherein isolating the second mixed mode refrigerant loop comprises trapping a portion of the working fluid in a second evaporator of the second mixed mode refrigerant loop and isolating the second evaporator from the heat exchanger.
A19. The method of any of items A16-A18, wherein operating both the first mixed mode refrigerant loop and the second mixed mode refrigerant loop in pumped refrigerant mode comprises circulating a working fluid through a first evaporator of the first mixed mode refrigerant loop, a second evaporator of the second mixed mode refrigerant loop, and a heat exchanger;
   pumping a first refrigerant through a first condenser of the first mixed mode refrigerant loop and the first evaporator, thereby rejecting heat from the heat exchanger out of the first condenser; and
   pumping a second refrigerant through a second condenser of the second mixed mode refrigerant loop and the second evaporator, thereby rejecting heat from the heat exchanger out of the second condenser.
A20. The method of any of items A16-A19, wherein operating the first mixed mode refrigerant loop in compressed refrigerant mode and the second mixed mode refrigerant loop in pumped refrigerant mode comprises
   circulating a working fluid through a first evaporator of the first mixed mode refrigerant loop, a second evaporator of the second mixed mode refrigerant loop, and a heat exchanger;
   compressing a first refrigerant between the first evaporator and a first condenser of the first mixed mode refrigerant loop, thereby rejecting heat from the heat exchanger out of the first condenser; and
   pumping a second refrigerant through a second condenser of the second mixed mode refrigerant loop and the second evaporator, thereby rejecting heat from the heat exchanger out of the second condenser.
A21. The method of any of items A16-A20, wherein operating both the first mixed mode refrigerant loop and the second mixed mode refrigerant loop in compressed refrigerant mode comprises circulating a working fluid through a first evaporator of the first mixed mode refrigerant
   loop, a second evaporator of the second mixed mode refrigerant loop, and a heat
   exchanger;
   compressing a first refrigerant between the first evaporator and a first condenser of the first mixed mode refrigerant loop, thereby rejecting heat from the heat exchanger out of the first condenser; and
   compressing a second refrigerant between the second evaporator and a second condenser of the second mixed mode refrigerant loop, thereby rejecting heat from the heat exchanger out of the second condenser.
A22. A mixed mode modular cooling system comprising:
   a first mixed mode refrigerant loop including a first evaporator, a first condenser, a first pump configured to pump a first refrigerant through the first evaporator and the first condenser, and a first compressor configured to compress the first refrigerant between the first evaporator and the first condenser;
   a second mixed mode refrigerant loop including a second evaporator, a second condenser, a second pump configured to pump a second refrigerant through the second evaporator and the second condenser, and a second compressor configured to compress the second refrigerant between the second evaporator and the second condenser; and
   plumbing configured to permit a working fluid to circulate through a heat exchanger, the first evaporator, and the second evaporator.
A23. The system of item A22, wherein the plumbing further comprises:
   a first valve configured to selectively permit the working fluid to circulate through the first evaporator; and
   a second valve configured to selectively permit the working fluid to circulate through the second evaporator.
A24. The system of item A22 or item A23, wherein the plumbing further comprises:
   a first output valve configured to selectively permit the working fluid to flow out of the first evaporator and selectively prevent the working fluid from flowing from the first evaporator; and
   a second output valve configured to selectively permit the working fluid to flow out of the second evaporator and selectively prevent the working fluid from flowing from the second evaporator.
A25. The system of any of items A22-A24, wherein the plumbing further comprises:
   an input manifold between the first and second evaporators and the heat exchanger; and
   an output manifold between the first and second output valves and the heat exchanger.
A26. A method of operating a modular cooling system comprising:
   monitoring a cooling demand;
   starting a first mixed mode refrigerant loop in pumped refrigerant mode, as the cooling demand rises to a first demand level;
   switching the first mixed mode refrigerant loop from pumped refrigerant mode to compressed refrigerant mode, as the cooling demand rises from the first demand level to a second demand level;
   operating the first mixed mode refrigerant loop in compressed refrigerant mode and starting a second mixed mode refrigerant loop in pumped refrigerant mode, as the cooling demand rises from the second demand level to a third demand level; and
   operating the first mixed mode refrigerant loop in compressed refrigerant mode and switching the second mixed mode refrigerant loop from pumped refrigerant mode to compressed refrigerant mode, as the cooling demand rises from the third demand level to a fourth demand level.
A27. The method of item A26, wherein starting the first mixed mode refrigerant loop in pumped refrigerant mode comprises:
   opening a first flow valve; and
   starting a first pump, thereby pumping a first two-phase refrigerant through a first
   condenser and a first evaporator.
A28. The method of item A26 or item A27, wherein starting the second mixed mode refrigerant loop in pumped refrigerant mode comprises:
   opening a second flow valve; and
   starting a second pump, thereby pumping a second two-phase refrigerant through a
   second condenser and a second evaporator.
A29. The method of any of items A26-A28, wherein switching the first mixed mode refrigerant loop from pumped refrigerant mode to compressed refrigerant mode comprises:
   leaving the first flow valve open;
   stopping the first pump; and
   starting a first compressor, thereby compressing the first two-phase refrigerant between
   the first evaporator and the first condenser.
A30. The method of any of items A26-A29, wherein switching the second mixed mode refrigerant loop from pumped refrigerant mode to compressed refrigerant mode comprises:
   leaving the second flow valve open;
   stopping the second refrigerant pump; and
   starting a second compressor, thereby compressing the second two-phase refrigerant
   between the second evaporator and the second condenser.
A31. The method of any of items A26-A30, wherein the second demand level indicates greater cooling demand than the first demand level, wherein the third demand level indicates greater cooling demand than the second demand level, and wherein the fourth demand level indicates greater cooling demand than the third demand level.
A32. The method of any of items A26-A31, further comprising, as the cooling demand varies between the first demand level and the second demand level, varying a first pump speed of a first pump of the first mixed mode refrigerant loop.
A33. The method of any of items A26-A32, further comprising, as the cooling demand varies between the second demand level and the third demand level, varying a first compressor speed of a first compressor of the first mixed mode refrigerant loop.
A34. The method of any of items A26-A33, further comprising, as the cooling demand varies between the third demand level and the fourth demand level:
   running the first compressor at a first maximum compressor speed, wherein the first
   maximum compressor speed is the first compressor's maximum rated speed; and varying a second pump speed of a second pump of the second mixed mode refrigerant loop.
A35. The method of any of items A26-A34, further comprising, as the cooling demand varies between the third demand level and the fourth demand level:
   varying a first compressor speed of a first compressor; and
   running a second pump of the second mixed mode refrigerant loop at a second maximum pump speed, wherein the second maximum pump speed is the second pump's maximum rated speed.
   A36. The method of any of items A26-A35, further comprising, as the cooling demand varies above the fourth demand level:
   running the first compressor of the first refrigerant loop at the first maximum compressor speed; and
   varying a second compressor speed of a second compressor of the second mixed mode refrigerant loop.
A37. The method of any of items A26-A36, further comprising, as the cooling demand varies above the fourth demand level:
   varying a first compressor speed of a first compressor; and
   running a second compressor of the second mixed mode refrigerant loop at a second maximum compressor speed, wherein the second maximum compressor speed is the second compressor's maximum rated speed.
A38. The method of any of items A26-A37, wherein the first mixed mode refrigerant loop and the second mixed mode refrigerant loop have the same cooling capacity in pumped refrigerant mode.
A39. The method of any of items A26-A38, wherein the first mixed mode refrigerant loop and the second mixed mode refrigerant loop have different cooling capacities in pumped refrigerant mode.
A40. The method of any of items A26-A39, wherein the first mixed mode refrigerant loop and the second mixed mode refrigerant loop have the same cooling capacity in compressed refrigerant mode.
A41. The method of any of items A26-A40, wherein the first mixed mode refrigerant loop and the second mixed mode refrigerant loop have different cooling capacities in compressed refrigerant mode.
A42. A method of operating a modular cooling system comprising:
   monitoring a cooling demand;
   operating, as the cooling demand varies between a first demand level and a second demand level, a first mixed mode refrigerant loop in pumped refrigerant mode, while isolating a second mixed mode refrigerant loop;
   operating, as the cooling demand varies between the second demand level and a third demand level, the first mixed mode refrigerant loop in compressed refrigerant mode, while isolating the second mixed mode refrigerant loop;
   operating, as the cooling demand varies between the third demand level and a fourth demand level, the first mixed mode refrigerant loop in compressed refrigerant mode and the second mixed mode refrigerant loop in pumped refrigerant mode; and
   operating, as the cooling demand varies above the fourth demand level, both the first mixed mode refrigerant loop and the second mixed mode refrigerant loop in compressed refrigerant mode.
A43. The method of item A42, wherein operating the first mixed mode refrigerant loop in pumped refrigerant mode comprises:
   circulating a working fluid through a first evaporator of the first mixed mode refrigerant loop and a heat exchanger; and
   pumping a first refrigerant through a first condenser of the first mixed mode refrigerant loop and the first evaporator, thereby rejecting heat from the heat exchanger out of the first condenser.
A44. The method of item A42 or item A43, wherein operating the first mixed mode refrigerant loop in compressed refrigerant mode comprises:
   circulating a working fluid through a first evaporator of the first mixed mode refrigerant loop, a second evaporator of the second mixed mode refrigerant loop, and a heat exchanger; and
   compressing a first refrigerant between the first evaporator and a first condenser of the first mixed mode refrigerant loop, thereby rejecting heat from the heat exchanger out of the first condenser.
A45. The method of any of items A42-A44, wherein isolating the second mixed mode refrigerant loop comprises trapping a portion of the working fluid in a second evaporator of the second mixed mode refrigerant loop and isolating the second evaporator from the heat exchanger.
A46. The method of any of items A42-A45, wherein operating the first mixed mode refrigerant loop in compressed refrigerant mode and the second mixed mode refrigerant loop in pumped refrigerant mode comprises:
   circulating a working fluid through a first evaporator of the first mixed mode refrigerant loop, a second evaporator of the second mixed mode refrigerant loop, and a heat exchanger;
   compressing a first refrigerant between the first evaporator and a first condenser of the first mixed mode refrigerant loop, thereby rejecting heat from the heat exchanger out of the first condenser; and
   pumping a second refrigerant through a second condenser of the second mixed mode refrigerant loop and the second evaporator, thereby rejecting heat from the heat exchanger out of the second condenser.
A47. The method of any of items A42-A46, wherein operating both the first mixed mode refrigerant loop and the second mixed mode refrigerant loop in compressed refrigerant mode comprises: circulating a working fluid through a first evaporator of the first mixed mode refrigerant loop, a second evaporator of the second mixed mode refrigerant loop, and a heat exchanger;
   compressing a first refrigerant between the first evaporator and a first condenser of the first mixed mode refrigerant loop, thereby rejecting heat from the heat exchanger out of the first condenser; and
   compressing a second refrigerant between the second evaporator and a second condenser of the second mixed mode refrigerant loop, thereby rejecting heat from the heat exchanger out of the second condenser.
A48. A method of operating a modular cooling system comprising:
   operating a first mixed mode refrigerant loop in compressed refrigerant mode and a second mixed mode refrigerant loop in pumped refrigerant mode;
   monitoring a cooling demand;
   operating the first mixed mode refrigerant loop in compressed refrigerant mode and switching the second mixed mode refrigerant loop from pumped refrigerant mode to compressed refrigerant mode, as the cooling demand rises; and
   operating the second mixed mode refrigerant loop in pumped refrigerant mode and switching the first mixed mode refrigerant loop from compressed refrigerant mode to pumped refrigerant mode, as the cooling demand falls.
A49. A method as shown and/or described herein.
A50. A system as shown and/or described herein.
A51. A device as shown and/or described herein.
A52. A system comprising one or more controllers configured to perform or cause the performance of a method as shown and/or described herein.
A53. A non-transitory computer readable medium having instructions stored thereon that, when executed by a processer, cause the processor to perform or cause the performance of a method as shown and/or described herein.

## Claims

1. A method of operating a modular cooling system comprising:
monitoring a cooling demand;
starting a first mixed mode refrigerant loop in pumped refrigerant mode, as the cooling demand rises to a first demand level;
operating the first mixed mode refrigerant loop in pumped refrigerant mode and starting a second mixed mode refrigerant loop in pumped refrigerant mode, as the cooling demand rises from the first demand level to a second demand level;
operating the second mixed mode refrigerant loop in pumped refrigerant mode and switching the first mixed mode refrigerant loop from pumped refrigerant mode to compressed refrigerant mode, as the cooling demand rises from the second demand level to a third demand level; and
operating the first mixed mode refrigerant loop in compressed refrigerant mode and switching the second mixed mode refrigerant loop from pumped refrigerant mode to compressed refrigerant mode, as the cooling demand rises from the third demand level to a fourth demand level.

2. The method of claim 1, wherein starting the first mixed mode refrigerant loop in pumped refrigerant mode comprises:
opening a first flow valve; and
starting a first pump, thereby pumping a first two-phase refrigerant through a first condenser and a first evaporator.

3. The method of claim 1 or claim 2, wherein starting the second mixed mode refrigerant loop in pumped refrigerant mode comprises:
opening a second flow valve; and
starting a second pump, thereby pumping a second two-phase refrigerant through a second condenser and a second evaporator.

4. The method of claim 2, wherein switching the first mixed mode refrigerant loop from pumped refrigerant mode to compressed refrigerant mode comprises leaving the first flow valve open;
stopping the first pump; and
starting a first compressor, thereby compressing the first two-phase refrigerant between the first evaporator and the first condenser.

5. The method of claim 3, wherein switching the second mixed mode refrigerant loop from pumped refrigerant mode to compressed refrigerant mode comprises leaving the second flow valve open;
stopping the second pump; and
starting a second compressor, thereby compressing the second two-phase refrigerant between the second evaporator and the second condenser.

6. The method of claim 1, further comprising, as the cooling demand varies between the first demand level and the second demand level, varying a first pump speed of a first pump of the first mixed mode refrigerant loop; wherein the second demand level indicates greater cooling demand than the first demand level; wherein the third demand level indicates greater cooling demand than the second demand level; and wherein the fourth demand level indicates greater cooling demand than the third demand level.

7. The method of claim 6, further comprising, as the cooling demand varies between the second demand level and the third demand level;
running the first pump at a first maximum pump speed, wherein the first maximum pump speed is the first pump's maximum rated speed; and
varying a second pump speed of a second pump of the second mixed mode refrigerant loop.

8. The method of claim 7, further comprising, as the cooling demand varies between the third demand level and the fourth demand level;
running the second pump at a second maximum pump speed, wherein the second
maximum pump speed is the second pump's maximum rated speed; and varying a first compressor speed of a first compressor of the first mixed mode refrigerant loop.

9. The method of claim 7, further comprising, as the cooling demand varies between the third demand level and the fourth demand level;
running a first compressor of the first mixed mode refrigerant loop at a first maximum compressor speed, wherein the first maximum compressor speed is the first compressor's maximum rated speed; and
varying the second pump speed of the second pump.

10. The method of claim 9, further comprising, as the cooling demand varies above the fourth demand level;
running the first compressor at the first maximum compressor speed; and
varying a second compressor speed of a second compressor of the second mixed mode refrigerant loop.

11. A mixed mode modular cooling system comprising:
a first mixed mode refrigerant loop including a first evaporator, a first condenser, a first pump configured to selectively pump a first refrigerant through the first evaporator and the first condenser, and a first compressor configured to selectively compress the first refrigerant between the first evaporator and the first condenser;
a second mixed mode refrigerant loop including a second evaporator, a second condenser, a second pump configured to selectively pump a second refrigerant through the second evaporator and the second condenser, and a second compressor configured to selectively compress the second refrigerant between the second evaporator and the second condenser; and
plumbing configured to permit a working fluid to circulate through a heat exchanger, the first evaporator, and the second evaporator.

12. The system of claim 11, wherein the plumbing further comprises:
a first valve configured to selectively permit the working fluid to circulate through the first evaporator; and
a second valve configured to selectively permit the working fluid to circulate through the second evaporator.

13. The system of claim 11 or claim 12, wherein the plumbing further comprises:
a first output valve configured to selectively permit the working fluid to flow out of the first evaporator and selectively prevent the working fluid from flowing from the first evaporator; and
a second output valve configured to selectively permit the working fluid to flow out of the second evaporator and selectively prevent the working fluid from flowing from the second evaporator.

14. The system of claim 13, wherein the plumbing further comprises:
an input manifold disposed fluidically between the first and second evaporators, and the heat exchanger, respectively; and
an output manifold disposed fluidically between the first and second output valves, and the heat exchanger, respectively.
